# EUROPEAN PATENT SPECIFICATION

(11) **EP 4 561 291 B1**
(45) Date of publication and mention of the grant of the patent: **08.07.2026**
(21) Application number: 24190867.2
(22) Date of filing: 25.07.2024
(51) Int. Cl.: H10D 30/66, H10D 89/60

(54) **TRENCH-TYPE SEMICONDUCTOR POWER DEVICE**
GRABEN-HALBLEITERLEISTUNGSBAUELEMENT
DISPOSITIF DE PUISSANCE À SEMI-CONDUCTEUR DE TYPE À TRANCHÉE

(30) Priority: 23.11.2023 CN 202311575226
(43) Date of publication of application: 28.05.2025
(73) Proprietor: Diodes Incorporated, Plano, Texas 75024 (US)
(72) Inventor: KUO, Ta-Chuan, 231023 New Taipei City (TW); CHUANG, Chiao-Shun, 231023 New Taipei City (TW)
(74) Representative: Marks & Clerk LLP

(56) References cited:
- CN-A- 105 355 626
- CN-U- 210 296 387
- US-A1- 2018 301 537
- US-A1- 2019 043 853

## Description

### TECHNICAL FIELD

The present invention relates to a trench-type semiconductor power device, and more particularly, relates to a trench-type semiconductor power device having an electrostatic discharge protection structure.

### BACKGROUND

Semiconductor power devices are widely used in the fields of automotive electronics, switching power supplies, etc. Trench power devices, in which gate oxide layers are grown on the sidewalls of gate trenches and polysilicon is filled to form gates, are one of the most popular power switching devices at present. Trench power devices can improve device area utilization efficiency so that a larger device cell channel width per unit area can be obtained, thereby obtaining a larger current conducting capability.

Semiconductor power devices are susceptible to voltage spikes caused by electrostatic discharge (ESD) events (including the human-body model or the machine model). Large instantaneous currents and voltages caused by ESD events can cause gate oxide layers of trench power devices to be broken down, thereby causing damage, even burning or causing high current leakage. Therefore, a trench-type semiconductor power device having an ESD protection structure is required.
US20190043853A1 discloses a semiconductor device having an ESD protection diode and a vertical MOSFET in which desired ESD tolerance is obtained without reducing the active region size or increasing the chip size. The semiconductor device includes: a substrate; a drain region and a source region in the substrate; a base region between the drain region and the source region; a gate electrode comprising a first polysilicon layer, and being in contact with the base region across a gate insulating film so that a channel is formed in the base region; and a bidirectional diode in which the gate electrode, a second polysilicon layer, and a third polysilicon layer are arranged in the stated order in a direction perpendicular to a front surface of the substrate.

### SUMMARY

Embodiments of the present disclosure relate to a trench-type semiconductor power device. The trench-type semiconductor power device includes: a substrate having a first conductivity type; an epitaxial layer that is located on the substrate and has the first conductivity type; a body doped region that is located in the epitaxial layer and away from the substrate and that has a second conductivity type; a source doped region that is located in the body doped region and away from the substrate and that has the first conductivity type; and a trench structure that has a first depth in a first direction extending from the source doped region to the substrate and that comprises a first semiconductor layer extending in a second direction, the first direction being perpendicular to the second direction. The first semiconductor layer includes: a first part that is adjacent to the body doped region and the source doped region, and serves as a gate electrode having the first conductivity type; and a second part that extends in the second direction and away from the source doped region, and comprises a plurality of first doped regions having the first conductivity type and a plurality of second doped regions having the second conductivity type, wherein the plurality of first doped regions and the plurality of second doped regions are arranged alternately in the second direction to form a first diode string having one or more back-to-back diodes. A first end of the first diode string is electrically connected to the gate electrode, and a second end of the first diode string is electrically connected to the source doped region by means of a first connection structure.

The epitaxial layer may be an example of a "lightly doped region". With the expression "a first part that is adjacent to the body doped region and the source doped region", it would be understood that the first part is separated from the body doped region and the source doped region by an insulating layer (which serves as the gate dielectric layer).

With the expression "staggered", it is meant that the plurality of first doped regions and the plurality of second doped regions are arranged alternately (i.e., a first doped region is arranged immediately between two of the second doped regions and/or a second doped region is arranged immediately between two of the first doped regions) to form the first diode string. The expression "staggered" may therefore be used interchangeably with "arranged alternately" in the present disclosure.

With regard to "back-to-back diode", it would be understood that a back-to-back diode has two diodes connected in an opposing orientation, with their anodes (or their cathodes) directly connected to each other, and allows bidirectional conduction. Therefore, the expression "back-to-back diode" may be used interchangeably with "a pair of diodes connected in an opposing orientation".

Interfaces between each second doped region and two first doped regions adjacent to the respective second doped region may form a first PN junction and a second PN junction of each of the back-to-back diodes.

The first semiconductor layer may further comprise: a third part that extends in the second direction and distant from the source doped region, that is disposed between the first part and the second part, and that has the first conductivity type,

The first end of the first diode string may be electrically connected to a second connection structure.

The third part of the first semiconductor layer may form a gate resistor.

The first semiconductor layer may comprise polysilicon, silicon carbide, gallium nitride, gallium oxide or diamond-based materials.

The trench structure may further comprise: an insulating layer that surrounds the first semiconductor layer so that the first semiconductor layer is separated from the lightly doped region, the body doped region and the source doped region.

The trench-type semiconductor power device may further comprise: an electrostatic discharge protection structure that is located above or in the same horizontal plane as the first semiconductor layer, and comprises: a second semiconductor layer that comprises a plurality of third doped regions having the first conductivity type and a plurality of fourth doped regions having the second conductivity type, wherein the plurality of third doped regions and the plurality of fourth doped regions are staggered to form a second diode string having one or more back-to-back diodes, wherein a first end of the second diode string is electrically connected to the source doped region by means of the first connection structure, and a second end of the second diode string is electrically connected to the first end of the first diode string by means of a second connection structure.

The first semiconductor layer may be separated from the electrostatic discharge protection structure.

The electrostatic discharge protection structure may be located above the first semiconductor layer, and the second part of the first semiconductor layer may abut against the second semiconductor layer of the electrostatic discharge protection structure.

The trench-type semiconductor power device may further comprise: a shielding structure that surrounds the trench structure, is separated from the first diode string by penetrating through the lightly doped region and the body doped region, and comprises a second semiconductor layer, wherein the second semiconductor layer comprises: a fourth part that has the first conductivity type and is connected to the source doped region by means of the first connection structure, wherein in the first direction, the depth of the shielding structure is greater than the first depth.

The second semiconductor layer may further comprise: a fifth part that is distant from the source doped region and that comprises a plurality of third doped regions having the first conductivity type and a plurality of fourth doped regions having the second conductivity type, wherein the plurality of third doped regions and the plurality of fourth doped regions are staggered to form one or more second diode strings, wherein each second diode string comprises one or more back-to-back diodes, and a first end of each second diode string is connected to the first end of the first diode string by means of a second connection structure and a second end thereof is connected to the source doped region by means of the first connection structure.

The trench-type semiconductor power device may further comprise: an electrostatic discharge protection structure that is located above or in the same horizontal plane as the first semiconductor layer, and comprises: a third semiconductor layer that comprises a plurality of fifth doped regions having the first conductivity type and a plurality of sixth doped regions having the second conductivity type, wherein the plurality of fifth doped regions and the plurality of sixth doped regions are staggered to form a third diode string having one or more back-to-back diodes, wherein a first end of the third diode string is electrically connected to the first end of the first diode string, and a second end of the third diode string is electrically connected to the source doped region.

The shielding structure may be disposed between the electrostatic discharge protection structure and the first diode string, and may be separated from the electrostatic discharge protection structure.

The shielding structure may be disposed between the electrostatic discharge protection structure and the first diode string, and the second semiconductor layer of the shielding structure may abut against the third semiconductor layer of the electrostatic discharge protection structure.

The trench-type semiconductor power device may further comprise: a shielding structure comprising a second semiconductor layer having the first conductivity type, wherein the trench structure further comprises: a third semiconductor layer located between the first semiconductor layer and the lightly doped region, wherein the third semiconductor layer comprises: a fourth part that has the first conductivity type and overlaps the first semiconductor layer in the first direction; and a fifth part that is adjacent to the first diode string and that does not overlap the first semiconductor layer in the first direction, wherein the first semiconductor layer is separated from the third semiconductor layer by penetrating through an insulating layer, and wherein the shielding structure is adjacent to the fifth part of the third semiconductor layer and separated from the trench structure by penetrating through the lightly doped region and the body doped region.

In the first direction, the thickness of the fourth part of the third semiconductor layer and the thickness of the first semiconductor layer may be less than the first depth.

The fifth part of the third semiconductor layer may have the first conductivity type, and the third semiconductor layer and the second semiconductor layer may be electrically connected to the source doped region by means of the first connection structure.

The fifth part of the third semiconductor layer may comprise a plurality of third doped regions having the first conductivity type and a plurality of fourth doped regions having the second conductivity type, wherein the plurality of third doped regions and the plurality of fourth doped regions are staggered to form a second diode string having one or more back-to-back diodes, wherein a first end of the second diode string is connected to the first end of the first diode string by means of a second connection structure, and a second end of the second diode string is connected to the source doped region by means of the first connection structure.

The trench-type semiconductor power device may further comprise: an electrostatic discharge protection structure that is located above or in the same horizontal plane as the first semiconductor layer, and comprises: a fourth semiconductor layer that comprises a plurality of fifth doped regions having the first conductivity type and a plurality of sixth doped regions having the second conductivity type, wherein the plurality of fifth doped regions and the plurality of sixth doped regions are staggered to form a third diode string having one or more back-to-back diodes, wherein a first end of the third diode string is connected to the first end of the first diode string by means of the second connection structure, and a second end of the third diode string is connected to the source doped region by means of the first connection structure.

The shielding structure may be disposed between the electrostatic discharge protection structure and the trench structure, and may be separated from the electrostatic discharge protection structure.

The shielding structure may be disposed between the electrostatic discharge protection structure and the trench structure, and the second semiconductor layer of the shielding structure may abut against the fourth semiconductor layer of the electrostatic discharge protection structure.

Where appropriate any of the optional features described above may be in any appropriate combination with any other optional feature(s) described herein.

### BRIEF DESCRIPTION OF THE DRAWINGS

When the following detailed description is read with reference to the accompanying drawings, aspects of several embodiments of the present disclosure may be best understood. It should be noted that various structures may not be drawn to scale. Indeed, for clarity of discussion, the dimensions of the various structures can be arbitrarily enlarged or reduced.
FIG. 1 is a circuit diagram of a trench-type semiconductor power device according to some embodiments of the present disclosure;
FIG. 2 is a top view of a trench-type semiconductor power device according to some embodiments of the present disclosure;
FIGS. 3A and 3B are cross-sectional views of the trench-type semiconductor power device shown in FIG. 2 along line A-A' and line B-B', respectively.
FIG. 4 is a top view of a trench-type semiconductor power device according to some embodiments of the present disclosure;
FIGS. 5A and 5B are cross-sectional views of the trench-type semiconductor power device shown in FIG. 4 along line A-A' and line B-B', respectively.
FIG. 6 is a top view of a trench-type semiconductor power device according to some embodiments of the present disclosure;
FIGS. 7A and 7B are cross-sectional views of the trench-type semiconductor power device shown in FIG. 6 along line A-A' and line B-B', respectively.
FIG. 8 is a top view of a trench-type semiconductor power device according to some embodiments of the present disclosure;
FIGS. 9A and 9B are cross-sectional views of the trench-type semiconductor power device shown in FIG. 8 along line A-A' and line B-B', respectively.
FIG. 10 is a top view of a trench-type semiconductor power device according to some embodiments of the present disclosure;
FIGS. 11A and 11B are cross-sectional views of the trench-type semiconductor power device shown in FIG. 10 along line A-A' and line B-B', respectively.
FIG. 12 is a top view of a trench-type semiconductor power device according to some embodiments of the present disclosure;
FIGS. 13A and 13B are cross-sectional views of the trench-type semiconductor power device shown in FIG. 12 along line A-A' and line B-B', respectively.
FIG. 14 is a top view of a trench-type semiconductor power device according to some embodiments of the present disclosure;
FIGS. 15A and 15B are cross-sectional views of the trench-type semiconductor power device shown in FIG. 14 along line A-A' and line B-B', respectively.
FIG. 16 is a top view of a trench-type semiconductor power device according to some embodiments of the present disclosure;
FIGS. 17A, 17B and 17C are cross-sectional views of the trench-type semiconductor power device shown in FIG. 16 along line A-A', line B-B' and line C-C', respectively;
FIG. 18 is a top view of a trench-type semiconductor power device according to some embodiments of the present disclosure;
FIGS. 19A, 19B and 19C are cross-sectional views of the trench-type semiconductor power device shown in FIG. 18 along line A-A', line B-B' and line C-C', respectively;
FIG. 20 is a top view of a trench-type semiconductor power device according to some embodiments of the present disclosure;
FIGS. 21A, 21B and 21C are cross-sectional views of the trench-type semiconductor power device shown in FIG. 20 along line A-A', line B-B' and line C-C', respectively;
FIG. 22 is a top view of a trench-type semiconductor power device according to some embodiments of the present disclosure;
FIGS. 23A and 23B are cross-sectional views of the trench-type semiconductor power device shown in FIG. 22 along line A-A' and line B-B', respectively.
FIG. 24 is a top view of a trench-type semiconductor power device according to some embodiments of the present disclosure;
FIGS. 25A and 25B are cross-sectional views of the trench-type semiconductor power device shown in FIG. 24 along line A-A' and line B-B', respectively.
FIG. 26 is a top view of a trench-type semiconductor power device according to some embodiments of the present disclosure;
FIGS. 27A and 27B are cross-sectional views of the trench-type semiconductor power device shown in FIG. 26 along line A-A' and line B-B', respectively.
FIG. 28 is a top view of a trench-type semiconductor power device according to some embodiments of the present disclosure; and
FIGS. 29A and 29B are cross-sectional views of the trench-type semiconductor power device shown in FIG. 28 along line A-A' and line B-B', respectively.

The same or similar components are denoted with the same reference signs in the drawings and detailed description. Several embodiments of the present disclosure will be immediately understood from the following detailed description with reference to the accompanying drawings.

### DETAILED DESCRIPTION OF THE EMBODIMENTS

The following disclosure provides numerous different embodiments or examples for implementing different features of the presented subject matter. Specific examples of components and configurations will be described below. Of course, these are merely examples and are not intended to be limiting. In the present disclosure, the reference to forming a first feature above or on a second feature may include an embodiment in which the first feature and the second feature are formed in direct contact, and may further include an embodiment in which another feature may be formed between the first feature and the second feature such that the first feature and the second feature may not be in direct contact. Moreover, reference numerals and/or letters may be repeated in various examples of the present disclosure. This repetition is for simplicity and clarity, and does not per se indicate the relationship between the embodiments and/or configurations discussed.

The embodiments of the present disclosure will be discussed in detail below. However, it should be understood that the present disclosure provides a number of applicable concepts that can be embodied in a wide variety of particular environments. The specific embodiments discussed are merely illustrative and do not limit the scope of the present disclosure.

The present disclosure provides a trench-type semiconductor power device. Compared with general trench-type semiconductor power devices, the trench-type semiconductor power device of the present disclosure is formed in a cell region, and has diodes capable of providing electrostatic discharge (ESD) protection in the cell region. The trench-type semiconductor power device has diode strings that are formed, in trenches, by one or more back-to-back diodes. When an ESD event occurs, an instantaneous large current will be directed out of the trench-type semiconductor power device by means of the diode strings in the trench, so that damage caused by the instantaneous large current to a gate of a power transistor in a trench can be avoided. Compared with power devices that require additional use of an ESD protection circuit, the trench-type semiconductor power device of the present disclosure can ensure that the power device is protected by diode strings in trenches, thereby increasing the reliability of the power device. Furthermore, the diode strings formed in the trenches will not affect the configuration of a gate pad, therefore, there is flexibility in circuit design and layout, and manufacturing costs can be reduced.

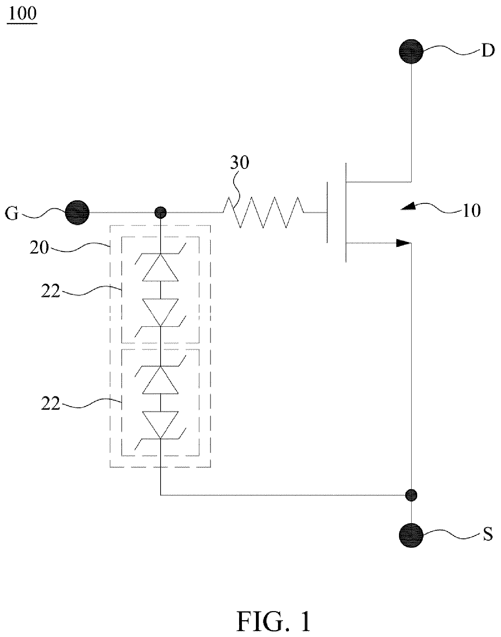

FIG. 1 is a circuit diagram of a trench-type semiconductor power device 100 according to some embodiments of the present disclosure. The trench-type semiconductor power device 100 has a gate terminal G, a drain terminal D and a source terminal S, and includes a vertical power transistor 10, a gate resistor 30 and a diode string 20. The vertical power transistor 10 may be a different type of semiconductor power device or fabricated by a different technology, and has a vertical current conduction path. A source and a drain of the vertical power transistor 10 are connected to the source terminal S and the drain terminal D, respectively. In the embodiments of FIG. 1, the vertical power transistor 10 is an N-type transistor. In other embodiments, the vertical power transistor 10 may be a P-type transistor.

A gate of the vertical power transistor 10 is coupled to the gate terminal G by means of the gate resistor 30. The diode string 20 is coupled between the gate terminal G and the source terminal S. The diode string 20 is formed from one or more back-to-back diodes 22 connected in series, and the number of back-to-back diode 22 is determined by the voltage resistance (e.g., the breakdown voltage of a gate oxide layer of the vertical power transistor 10) of the trench-type semiconductor power device 100. In the embodiments of FIG. 1, the diode string 20 includes two back-to-back diodes 22 connected in series as an illustration. In other embodiments, the diode string 20 may be formed from more or fewer back-to-back diodes 22.

When an ESD event occurs, the gate resistor 30 may prevent an instantaneous large current from the gate terminal G from directly attacking the gate (e.g., a gate oxide) of the vertical power transistor 10. In addition, the instantaneous large current caused by the ESD event will flow through the diode string 20 to the source terminal S in order to be transferred away from the vertical power transistor 10 (e.g., to be transferred to a ground terminal). In other words, when the ESD event occurs, the gate resistor 30 and the diode string 20 may provide ESD protection to the vertical power transistor 10.

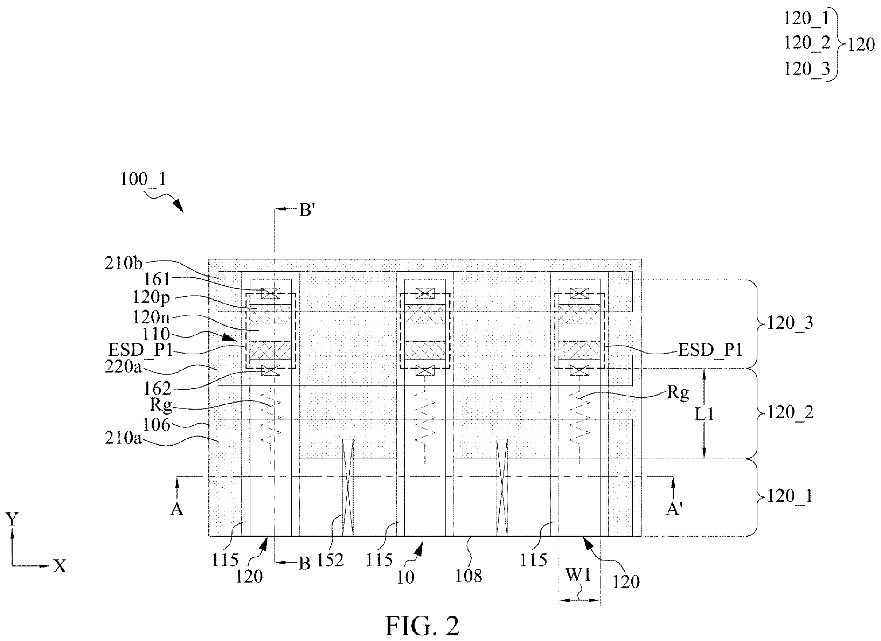

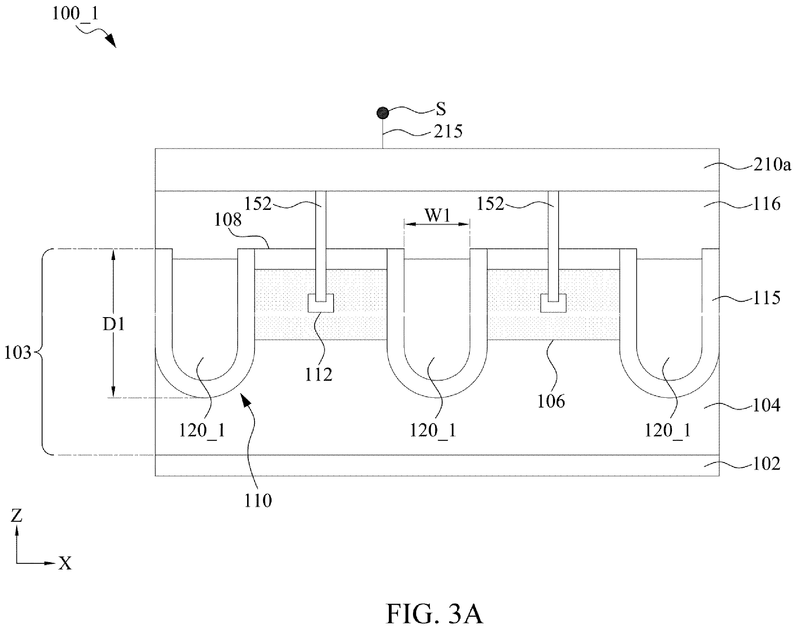

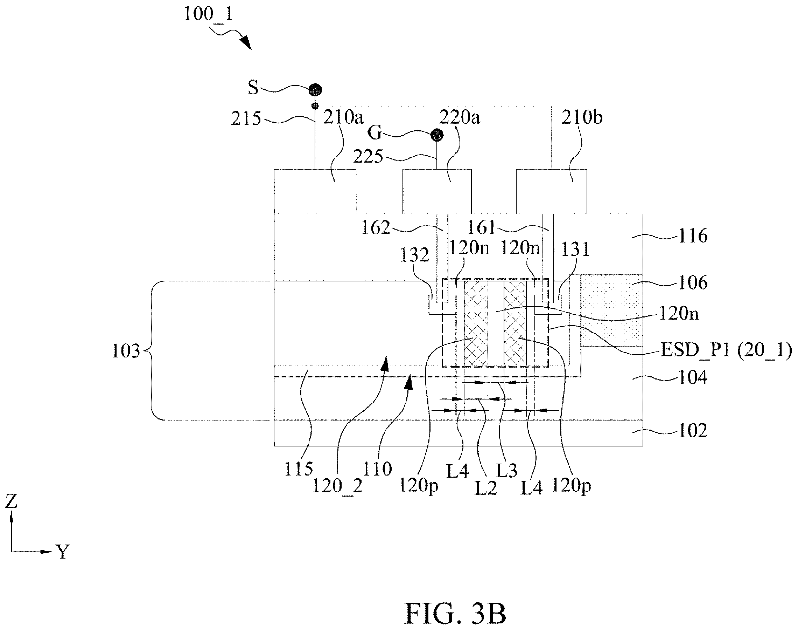

FIG. 2 is a top view (or layout diagram) of a trench-type semiconductor power device 100_1 according to some embodiments of the present disclosure. FIG. 3A is a cross-sectional view of the trench-type semiconductor power device 100_1 shown in FIG. 2 along line A-A' and FIG. 3B is a cross-sectional view of the trench-type semiconductor power device 100_1 shown in FIG. 2 along line B-B'. Line A-A' extends along an X direction, and line B-B' extends along a Y direction.

In some embodiments, the trench-type semiconductor power device 100_1 includes a semiconductor material layer 103, trench structures 110, conductive plugs 152, 161 and 162, and metal wires (or electrodes) 210a, 210b and 220a. The metal wires 210a, 210b and 220a are formed in a metal layer (e.g., an M1 layer) closest to the semiconductor material layer 103 in an interconnect structure. In some embodiments, the metal wires 210a, 210b and 220a extend in the X direction and are parallel to each other. In some embodiments, the width of the metal wire 210a is greater than the widths of the metal wires 210b and 220a, and the widths of the metal wires 210b and 220a are the same, the widths being measured in the Y direction. Materials of the metal wires 210a, 210b and 220a may include copper (Cu), gold (Au), silver (Ag), aluminum (Al), nickel (Ni), titanium (Ti), tungsten (W), tin (Sn), or other metals or alloys.

The semiconductor material layer 103 may include, for example, an N-type or P-type monocrystalline silicon material, an epitaxial silicon material, silicon carbide (SiC), germanium (Ge), silicon germanium (SiGe), gallium nitride (GaN), gallium arsenide (GaAs), gallium arsenide phosphide (GaAsP), or other semiconductor materials. In some embodiments, the semiconductor material layer 103 is an N-type (first conductivity type) epitaxial material. For ease of illustration, using the N-type semiconductor material layer 103 as an example, the semiconductor material layer 103 has an N-type lightly doped region 104 to illustrate an N-type vertical power transistor 10, but the present disclosure is not limited to this. The N-type (first conductivity type) or P-type (second conductivity type) semiconductor material layer 103 may be adjusted depending on the conductivity type of the vertical power transistor 10.

A substrate 102 is formed on a lower surface of the semiconductor material layer 103, and has the same conductivity type doping as the lightly doped region 104, e.g., N type. The substrate 102 is a drain contact region of the vertical power transistor 10, and is coupled to the source terminal S and used to contact a drain metal layer (not shown in drawings). In some embodiments, the substrate 102 may be disposed adjacent to an upper surface of a silicon wafer or another semiconductor material substrate. In some embodiments, the substrate 102 is part of the silicon wafer. Materials of the substrate 102 may include a monocrystalline silicon material, an epitaxial silicon material, silicon carbide (SiC), germanium (Ge), silicon-germanium (SiGe), gallium nitride (GaN), gallium arsenide (GaAs), gallium arsenide phosphide (GaAsP), or other semiconductor materials. In some embodiments, the doping concentration of the substrate 102 is greater than that of the lightly doped region 104.

The trench structures 110 extend in the Y direction, are parallel to each other, and have a depth D1 in the semiconductor material layer 103. The trench structures 110 may have vertical sidewalls and arc-shaped bottom surfaces. In some embodiments, the trench structures 110 may be circular, elliptical, rectangular, or polygonal. The trench structures 110 may be formed by an etching process (e.g., a plasma dry etching process) after locations and patterns are defined through a photoresist. Three trench structures 110 are shown in the embodiments of the trench-type semiconductor power device 100_1; the number of the trench structures 110 is merely an example, and not intended to limit the present disclosure.

Each of the trench structures 110 includes a semiconductor layer 120 extending in the Y direction and an insulating layer 115, wherein the semiconductor layer 120 has a width W1 in the X direction. The semiconductor layer 120 is surrounded by the insulating layer 115. The semiconductor layer 120 is formed from polysilicon, and can be divided into three parts 120_1, 120_2, and 120_3 (hereinafter referred to as first partial semiconductor layer 120_1, second partial semiconductor layer 120_2, and third partial semiconductor layer 120_3, respectively). In some embodiments, the trench-type semiconductor power device 100_1 further includes an interlayer dielectric layer 116 overlying the semiconductor material layer 103.

A doped region 106 is formed in the lightly doped region 104 of the semiconductor material layer 103 by means of an ion implantation process. The doped region 106 located between the first partial semiconductor layers 120_1 serves as a body doped region (hereinafter collectively referred to as body doped region 106) of the vertical power transistor 10. The body doped region 106 and the substrate 102 are located on two opposite sides of the lightly doped region 104 in a Z direction, respectively. The body doped region 106 has a different conductivity type than the lightly doped region 104, e.g., a P type. Electrically, the coverage area of the body doped region 106 will not have the characteristics of an N-type conductivity type. In other words, the body doped region 106 is located above the lightly doped region 104 and abuts against the lightly doped region 104. In the Z direction, the depth (or thickness) of the body doped region 106 is less than the depth D1 of the trench structure 110. In some embodiments, the semiconductor layer 120 includes silicon carbide (SiC), gallium nitride (GaN), gallium oxide (Ga2O3), or diamond-based materials.

A doped region 108 located between the first partial semiconductor layers 120_1 serves as a source (hereinafter collectively referred to as source doped region 108) of the vertical power transistor 10. The source doped region 108 is located in (or above) the body doped region 106 and distant from the substrate 102. The source doped region 108 has a depth that is less than the depth of the body doped region 106, and has a different conductivity type to the body doped region 106, e.g., the N type. In some embodiments, the doping concentration of the source doped region 108 is greater than that of the lightly doped region 104.

In the trench structure 110, the second partial semiconductor layer 120_2 is located between the first partial semiconductor layer 120_1 and the third partial semiconductor layer 120_3. The first partial semiconductor layer 120_1 and the second partial semiconductor layer 120_2 have the same conductivity type doping as the lightly doped region 104, e.g., the N type. In some embodiments, the doping concentration of the first partial semiconductor layer 120_1 and the doping concentration of the second partial semiconductor layer 120_2 are greater than the doping concentration of the lightly doped region 104. Furthermore, the first partial semiconductor layer 120_1 is a part of the semiconductor layer 120 adjacent to the source doped region 108 to serve as a gate electrode of the vertical power transistor 10. The second partial semiconductor layer 120_2 extends in the Y direction and away from the source doped region 108, and has a length L1 (e.g., the distance from the source doped region 108 to a conductive plug 162 in the Y direction) to serve as a gate resistor Rg. The impedance of the gate resistor Rg is determined by the ratio of the length L1 to the width W1 of the second partial semiconductor layer 120_2. The third partial semiconductor layer 120_3 is a part of the semiconductor layer 120 located between the conductive plugs 161 and 162 to serve as an ESD protection structure ESD_P1 that forms the diode string 20. The semiconductor layer 120 is separated from the semiconductor material layer 103 by means of the insulating layer 115. Furthermore, the ESD protection structure ESD_P1 (i.e., the third partial semiconductor layer 120_3) is further separated from the doped region 106 by means of the insulating layer 115. It is worth noting that an upper surface of the semiconductor layer 120 will be lower than upper surfaces of the source doped region 108 and the insulating layer 115 to ensure that the semiconductor layer 120 will not remain on the upper surface of the source doped region 108 after etching is performed; if the semiconductor layer 120 remained on the upper surface of the source doped region 108 after etching, then this would affect the characteristics of the source doped region 108 or cause a short circuit between the source doped region 108 and the semiconductor layer 120.

The ESD protection structure ESD_P1 includes a plurality of doped regions 120n and a plurality of doped regions 120p. The doped regions 120n and the doped regions 120p have different conductivity types. For example, the doped regions 120n have the same conductivity type doping as the lightly doped region 104, e.g., N type, and the doped regions 120p have the same conductivity type doping as the body doped region 106, e.g., P type. In some embodiments, the doping concentration of the doped region 120n is greater than that of the lightly doped region 104. An interface between the doped regions 120n and the doped regions 120p will form a PN junction. Furthermore, each of the doped regions 120p and two of the doped regions 120n adjacent to the doped region 120p will form one back-to-back diode 22, for example, interfaces between each of the doped regions 120p and two of the doped regions 120n adjacent to the doped region 120p respectively form a first PN junction and a second PN junction of the back-to-back diode 22. In an embodiment of the ESD protection structure ESD_P1, the doped regions 120n and the doped regions 120p are staggered to form a diode string having two back-to-back diodes 22 connected in series (hereinafter collectively referred to as diode string 20_1).

It is worth noting that in the diode string 20_1 of the ESD protection structure ESD_P1, the number of the back-to-back diodes 22 is determined by the voltage resistance (e.g., breakdown voltage) of a gate oxide layer of the vertical power transistor 10. For example, the greater the breakdown voltage of the gate oxide layer, the higher the number of back-to-back diodes 22 in the diode string 20_1, that is, the higher the number of doped regions 120n and doped regions 120p. Moreover, by forming the diode string 20_1 in the trench structure 110, no additional ESD protection circuit or structure is required, and thus manufacturing costs can be reduced.

The first partial semiconductor layer 120_1 overlaps the metal wire 210a and is completely covered by the metal wire 210a. The second partial semiconductor layer 120_2 partially overlaps the metal wire 210a. The second partial semiconductor layer 120_2 and the third partial semiconductor layer 120_3 partially overlap the metal wire 220a, and the metal wire 220a is connected to the second partial semiconductor layer 120_2 and the doped regions 120n of the third partial semiconductor layer 120_3 by means of the conductive plug 162. The third partial semiconductor layer 120_3 partially overlaps the metal wire 210b, and the metal wire 210b is connected to the doped regions 120n of the third partial semiconductor layer 120_3 by means of the conductive plug 161.

A heavily doped region 112 is located in the body doped region 106. The conductive plug 152 extends in the Z direction penetrating through the interlayer dielectric layer 116 to connect the metal wire 210a, as well as the source doped region 108 and the heavily doped region 112 in the semiconductor material layer 103. The heavily doped region 112 has a different conductivity type than the lightly doped region 106, e.g., the N type. In some embodiments, the doping concentration of the heavily doped region 112 is less than that of the source doped region 108. The metal wire 210a is connected to the source terminal S by means of an interconnect structure 215. In the embodiments of the present invention, other metal wires (not shown) or conductive plugs (not shown) that are electrically connected between the metal wire 210a and the source terminal S are collectively referred to as the interconnect structures 215. For ease of illustration, the metal wire 210a, the conductive plug 152 and the interconnect structure 215 may serve as a source connection structure.

A heavily doped region 132 is located between the second partial semiconductor layer 120_2 and the third partial semiconductor layer 120_3, and surrounds one end of the conductive plug 162. The conductive plug 162 extends in the Z direction penetrating through the interlayer dielectric layer 116 and extending to the semiconductor layer, so as to connect the metal wire 220a and the semiconductor layer 120. The heavily doped region 132 has the same conductivity type as the semiconductor layer 120, e.g., the N type. The metal wire 220a is connected to the gate terminal G by means of an interconnect structure 225. In the embodiments of the present invention, other metal wires (not shown) and conductive plugs (not shown) that are electrically connected between the metal wire 220a and the gate terminal G are collectively referred to as the interconnect structure 225. For ease of illustration, the metal wire 220a, the conductive plug 162 and the interconnect structure 225 may serve as a gate connection structure.

A heavily doped region 131 is located in the doped region 120n at the rearmost end of the third partial semiconductor layer 120_3 and surrounds one end of the conductive plug 161. The conductive plug 161 extends in the Z direction penetrating through the interlayer dielectric layer 116 and extends into the third partial semiconductor layer 120_3 to electrically connect the metal wire 210b and the doped region 120n at the rearmost end. The heavily doped region 131 has the same conductivity type as the doped region 120n, e.g., the N type. The metal wire 210b is connected to the source terminal S and the metal wire 210a by means of the interconnect structure 215. In the embodiments of the present invention, other metal wires (not shown) and conductive plugs (not shown) that are electrically connected between the metal wire 210b and the source terminal S are collectively referred to as the interconnect structures 215. In some embodiments, the metal wire 210b is connected to the metal wire 210a by passing through the interconnect structure 215 (e.g., an M2 metal wire and a corresponding conductive plug) located at the upper layer. In some embodiments, the metal wire 210b is connected to the metal wire 210a by passing through the interconnect structure 215 (e.g., an M1 metal wire) located at the same layer.

In the X direction, the doped regions 120p and the doped regions 120n have a width W1. In the Y direction, the length L2 of the doped regions 120p is greater than the length L3 of the doped regions 120n. In some embodiments, the length L2 is about 3-4 microns (*µ*m) and the length L3 is about 2 microns. Furthermore, distances from the heavily doped regions 131 and 132 to the doped regions 120p are each a length L4. In some embodiments, the length L4 is less than or equal to the length L3. The lengths L2, L3 and L4 are determined according to process parameters of the vertical power transistor 10.

In the trench-type semiconductor power device, the configuration of each of the conductive plugs may vary depending on process or electrical requirements. Materials of the conductive plugs may include gold (Au), silver (Ag), copper (Cu), platinum (Pt), palladium (Pd), tungsten (W), titanium (Ti), tantalum (Ta), molybdenum (Mo), or other metals or alloys. In some embodiments, the conductive plugs 161, 162 are in a columnar configuration. In some embodiments, the conductive plug 161 or 162 has approximately the same depth in the Z direction. In some embodiments, the conductive plug 152 has a configuration that is wide at the top and narrow at the bottom.

In each of the ESD protection structures ESD_P1, a first end of the diode string 20_1 (i.e., the doped region 120n abutting against the second partial semiconductor layer 120_2 or the doped region 120n provided with the heavily doped region 132) is electrically connected to a gate of the vertical power transistor 10 by means of the gate resistor Rg, and a second end of the diode string 20_1 (i.e., the doped region 120n away from the second partial semiconductor layer 120_2 or the doped region 120n provided with the heavily doped region 131) is electrically connected to the source doped region 108 by means of a source connection structure (e.g., the interconnect structure 215, etc.). In the embodiments of the trench-type semiconductor power device 100_1, the gate resistor 30 in FIG. 1 is formed from parallel connection of the gate resistors Rg in all of the trench structures 110, for example, from the parallel connection of three gate resistors Rg. The diode string 20 in FIG. 1 is formed from parallel connection of the diode strings 20_1 of all of the ESD protection structures ESD_P1, for example, from the parallel connection of three diode strings 20_1. In the trench-type semiconductor power device 100_1, when the number of the trench structures 110 is increased, the number of the ESD protection structures ESD_P1 is also increased, and so more ESD paths can be provided for the vertical power transistor 10, and thus the capability of ESD protection can be increased. In a conventional semiconductor power device that requires additional area to form an ESD protection structure, when the size of a power transistor is increased, additional designs and layouts are required to correspondingly adjust the size of an ESD protection structure. Therefore, compared with conventional methods that require additional area to form an ESD protection structure, the ESD protection structure according to the embodiments of the present disclosure is provided together with a gate structure, so that the effects of area and product size reduction can be achieved; and ESD protection is improved without a need for additional designs and layouts when the size of the power transistor 10 is increased. In addition, compared with conventional trench-type semiconductor power devices having a single trench resistor, the gate resistors Rg that are connected in parallel may reduce the impedance of the trench resistor, and thus the switching speed of the vertical power transistor 10 will not be reduced, and a better operation efficiency will be achieved.

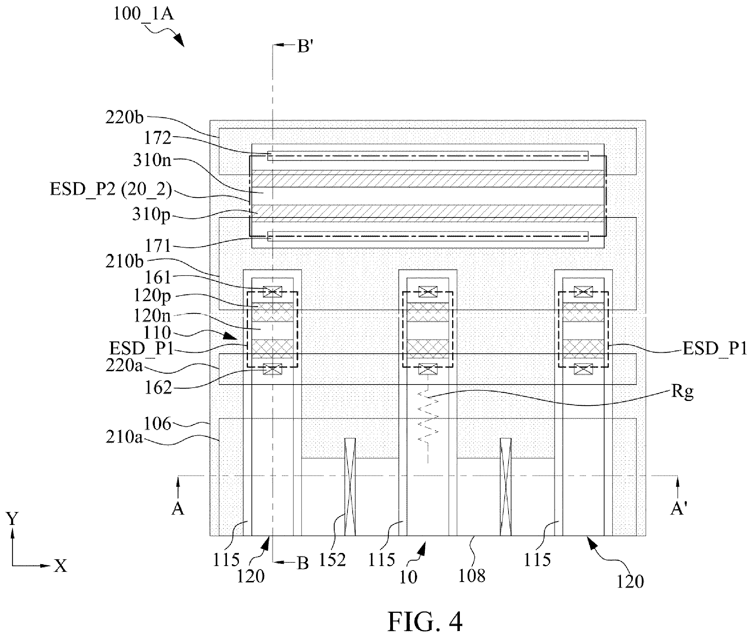

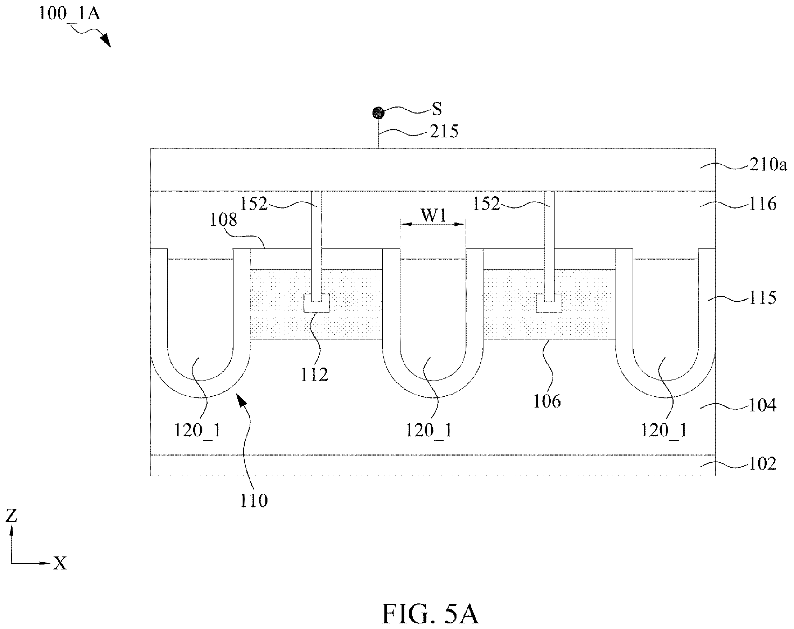

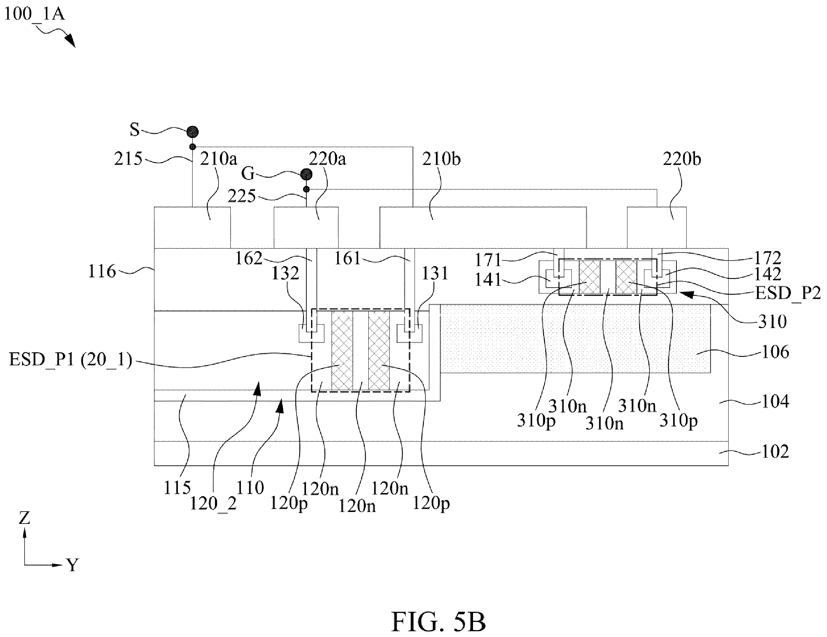

FIG. 4 is a top view of a trench-type semiconductor power device 100_1A according to some embodiments of the present disclosure. FIG. 5A is a cross-sectional view of the trench-type semiconductor power device 100_1A shown in FIG. 4 along line A-A', and FIG. 5B is a cross-sectional view of the trench-type semiconductor power device 100_1A shown in FIG. 4 along line B-B'. The structure configuration of the trench-type semiconductor power device 100_1A in FIG. 4 is similar to that of the trench-type semiconductor power device 100_1 in FIG. 2, and the difference between the two power devices is that the trench-type semiconductor power device 100_1A further includes an ESD protection structure ESD_P2. For the sake of concise description, only differences between different embodiments will be described below, and relevant descriptions of structures or process methods that are identical or similar to those in the foregoing embodiments will be omitted.

The ESD protection structure ESD_P2 includes a semiconductor layer 310 formed by plate-shaped polysilicon. The semiconductor layer 310 includes a plurality of doped regions 310n and a plurality of doped regions 310p, the doped regions 310n and the doped regions 310p having different conductivity types. For example, the doped regions 310n have the same conductivity type doping as the doped regions 120n, e.g., the N type, and the doped regions 310p have the same conductivity type doping as the doped regions 120p, e.g., the P type. In the ESD protection structure ESD_P2, the doped regions 310n and the doped regions 310p are staggered to form a diode string having two back-to-back diodes 22 connected in series (hereinafter collectively referred to as diode string 20_2). Furthermore, the number of the back-to-back diodes 22 in the diode string 20_2 is equal to the number of the back-to-back diodes 22 in the diode string 20_1. In some embodiments, in the X direction, the width of the doped regions 310p and 310n is greater than the width W1 of the doped regions 120p and 120n. In the Y direction, the doped regions 120p and 310p have the same length L2, and the doped regions 120n and 310n have the same length L3.

A heavily doped region 141 is located at the doped region 310n adjacent to the ESD protection structure ESD_P1 and surrounds one end of a conductive plug 171. The conductive plug 171 extends in the Z direction through the interlayer dielectric layer 116 and into the semiconductor layer 310 to connect the metal wire 210b. A heavily doped region 142 is located at the doped region 310n away from the ESD protection structure ESD _P1 and surrounds one end of a conductive plug 172. The conductive plug 172 extends in the Z direction through the interlayer dielectric layer 116 to connect the metal wire 220b. The metal wire 220b is connected to the gate terminal G and the metal wire 220a by means of the interconnect structure 225. The heavily doped regions 141 and 142 have the same conductivity type as the semiconductor layer 120, e.g., the N type. For ease of illustration, the metal wires and the conductive plugs connected to the interconnect structure 215 may serve as a source connection structure, and the metal wires and the conductive plugs connected to the interconnect structure 225 may serve as a gate connection structure.

In the trench-type semiconductor power device 100_1A, the ESD protection structure ESD _P2 is separated from the ESD protection structure ESD_P1 and surrounded by the interlayer dielectric layer 116. In addition, the semiconductor layer 310 of the ESD protection structure ESD _P2 is formed above the semiconductor layer 120 and overlaps the body doped region 106. Therefore, the depths of the conductive plugs 171 and 172 in the Z direction are less than those of the conductive plugs 161 and 162.

In the ESD protection structure ESD_P2, a first end (i.e., the doped region 120n away from the ESD protection structure ESD_P1, or the doped region 310n provided with the heavily doped region 142) of the diode string 20_2 is electrically connected to a gate resistor Rg by means of the gate connection structure (e.g., the metal wire 220b, the interconnect structure 225, etc.), and a second end (i.e., the doped region 120n adjacent to the ESD protection structure ESD_P1, or the doped region 310n provided with the heavily doped region 141) of the diode string 20_2 is electrically connected to the source doped region 108 by means of the source connection structure (e.g., the metal wire 210b, the interconnect structure 215, etc.). In the embodiments of the trench-type semiconductor power device 100_1A, the diode string 20 in FIG. 1 is formed from parallel connection of the diode strings 20_1 of all of the ESD protection structures ESD_P1 and the diode string 20_2 of the ESD protection structure ESD _P2, for example, formed from parallel connection of three diode strings 20_1 and the diode string 20_2. In the trench-type semiconductor power device 100_1A, more ESD paths can be provided to the vertical power transistor 10 by using the additional ESD protection structure ESD_P2, and thus ESD protection capability can be increased.

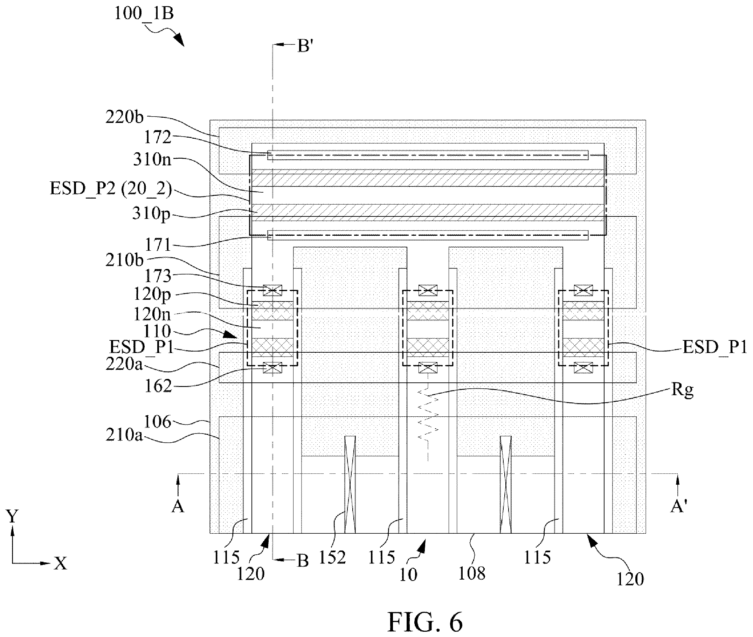

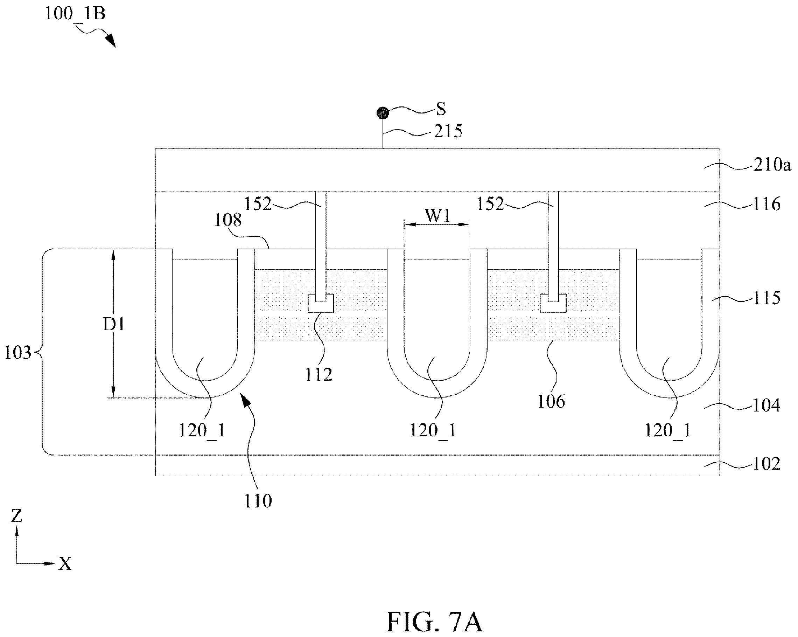

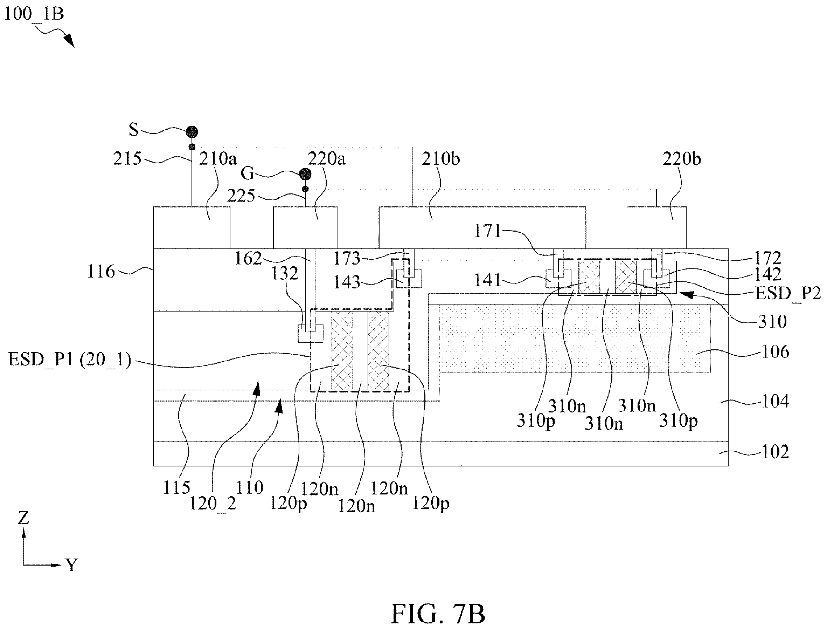

FIG. 6 is a top view of a trench-type semiconductor power device 100_1B according to some embodiments of the present disclosure. FIG. 7A is a sectional view of the trench-type semiconductor power device 100_1B shown in FIG. 6 along line A-A', and FIG. 7B is a sectional view of the trench-type semiconductor power device 100_1B shown in FIG. 6 along line B-B'. The structure configuration of the trench-type semiconductor power device 100_1B in FIG. 6 is similar to that of the trench-type semiconductor power device 100_1A in FIG. 4, and the difference between the two power devices is that a semiconductor layer 310 of the trench-type semiconductor power device 100_1B extends in the direction of the semiconductor layer 120 and is connected to the semiconductor layer 120, in other words, two ESD protection structures ESD_P1 and ESD_P2 of the trench-type semiconductor power device 100_1B are merged together by passing through the extended semiconductor layer 310.

The cross-sectional view of the trench-type semiconductor power device 100_1B shown in FIG. 7A is similar to FIGS. 3 and 6, and will not be repeated here. As shown in the trench-type semiconductor power device 100_1B in FIG. 7B, the semiconductor layer 310 forming the ESD protection structure ESD_P2 will extend in a Y direction to the ESD protection structure ESD_P1 to connect a doped region 120n at the rearmost end of the third partial semiconductor layer 120_3 extending in the Z direction, that is, the semiconductor layer 310 will abut against the semiconductor layer 120. Therefore, a conductive plug of the trench-type semiconductor power device 100_1B that is connected to a second end of the ESD protection structure ESD_P1 does not need to go deep into the semiconductor layer 120. In addition, the semiconductor layer 310 and the semiconductor layer 120 that are merged share the same gate material (e.g., polysilicon), and thus compared with the trench-type semiconductor power device 100_1A in which after the semiconductor layer 120 is formed, the gate material on the surface needs to be entirely etched and then the semiconductor layer 310 is re-formed, the trench-type semiconductor power device 100_1B can simplify process steps and thus reduce costs. The second end of the diode string 20_1 in the ESD protection structure ESD_P1 is electrically connected to the metal wire 210b by means of a heavily doped region 143 and a conductive plug 173. The heavily doped region 143 has the same conductivity type as the heavily doped regions 141 and 142. The depths of the conductive plugs 171-173 in the Z direction are the same. In some embodiments, the second end of the ESD protection structure ESD_P1 shares the same conductive plug 171 or 173 with the first end of the ESD protection structure ESD_P2, for example, only one of the conductive plugs 171 and 173 may be used according to design requirements. In some embodiments, the second end of the ESD protection structure ESD_P1 is connected to the first end of the ESD protection structure ESD_P2.

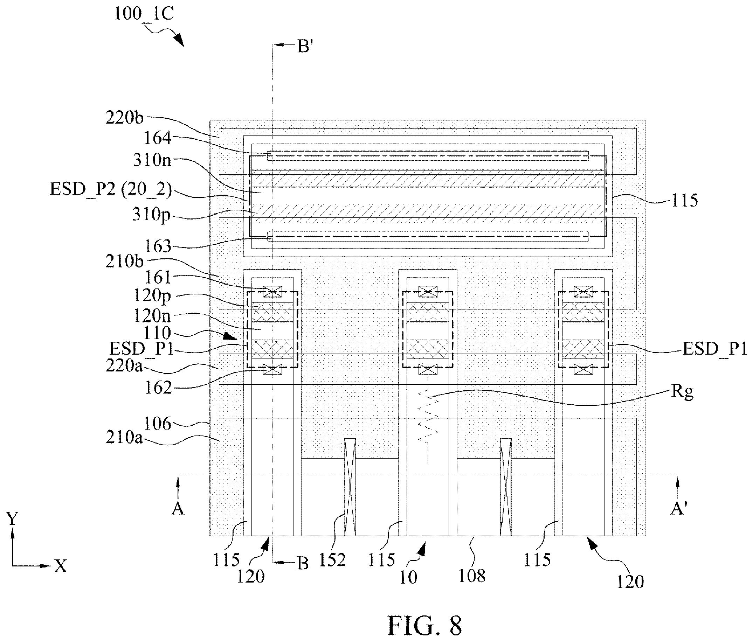

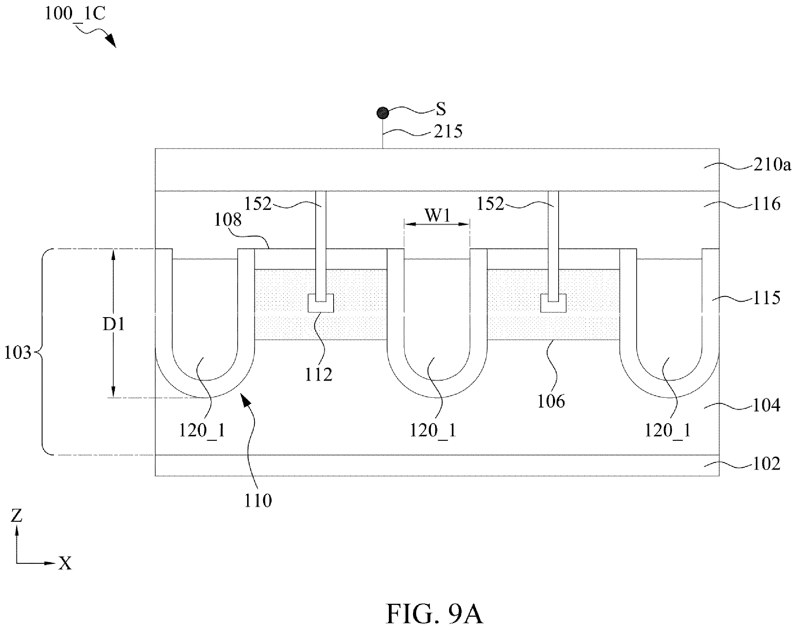

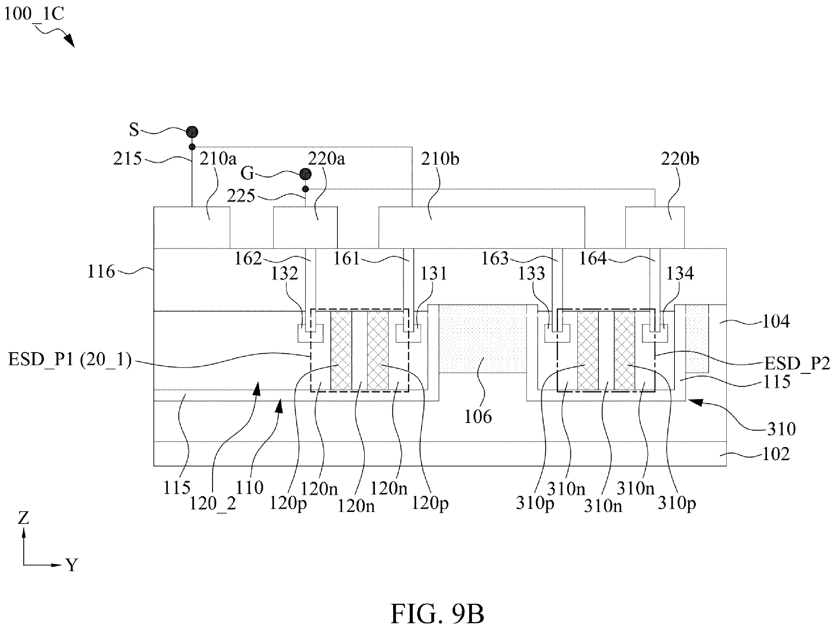

FIG. 8 is a top view of a trench-type semiconductor power device 100_1C according to some embodiments of the present disclosure. FIG. 9A is a cross-sectional view of the trench-type semiconductor power device 100_1C shown in FIG. 8 along line A-A', and FIG. 9B is a cross-sectional view of the trench-type semiconductor power device 100_1C shown in FIG. 8 along line B-B'. The structure configuration of the trench-type semiconductor power device 100_1C in FIG. 8 is similar to that of the trench-type semiconductor power device 100_1A in FIG. 4, and the difference between the two power devices is that ESD protection structures ESD_P1 and ESD _P2 of the trench-type semiconductor power device 100_1C are formed in the same horizontal plane and disposed in different trenches separated from each other.

In some embodiments of the trench-type semiconductor power device 100_1C, the semiconductor layer 310 of the ESD protection structure ESD_P2 has the same depth in the Z direction as the semiconductor layer 120 of the ESD protection structure ESD _P1. The trench of the ESD protection structure ESD_P2 may be formed at the same time as the trench structures 110, and at the same time, the insulating layer 115 will be underlaid in the trench of the ESD protection structure ESD_P2. The semiconductor layer 310 can be formed in the same step as the semiconductor layer 120, and surrounded by the insulating layer 115. The first end of the diode string 20_2 in the ESD protection structure ESD _P2 is electrically connected to the metal wire 220b by means of a heavily doped region 134 and a conductive plug 164, and the second end of the diode string 20_2 is electrically connected to the metal wire 210b by means of a heavily doped region 133 and a conductive plug 163. The heavily doped regions 133 and 134 have the same conductivity type as the heavily doped regions 131 and 132. The heavily doped regions 133 and 134 can be formed in the same step as the heavily doped regions 131 and 132, and thus have the same or similar configuration as the heavily doped regions 131 and 132, and the locations of the heavily doped regions 133 and 134 in the semiconductor layer 310 also correspond to the locations of the heavily doped regions 131 and 132 in the semiconductor layer 120. The depths of the conductive plugs 161-164 in the Z direction are the same. In the present embodiment, the same or similar process steps may be used to implement the ESD protection structures ESD_P1 and ESD_P2, therefore manufacturing costs may be reduced.

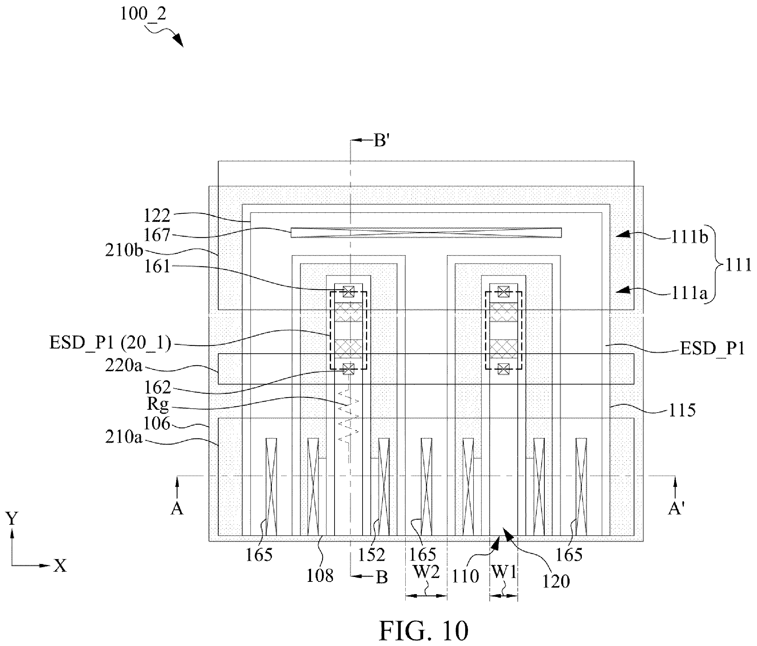

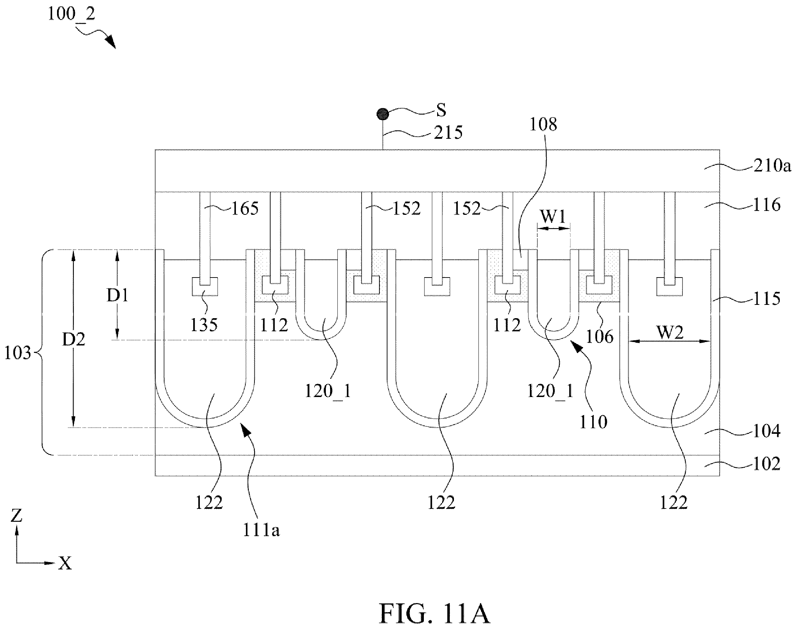

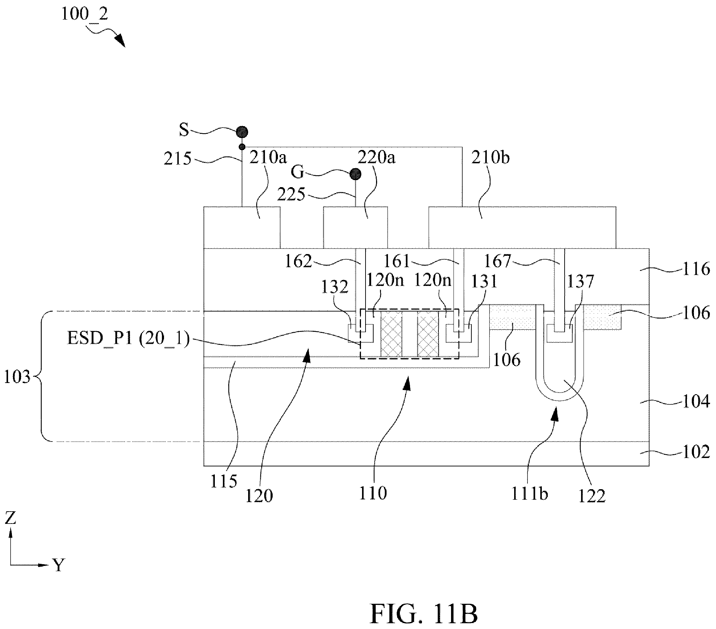

FIG. 10 is a top view of a trench-type semiconductor power device 100_2 according to some embodiments of the present disclosure. FIG. 11A is a cross-sectional view of the trench-type semiconductor power device 100_2 shown in FIG. 10 along line A-A', and FIG. 11B is a cross-sectional view of the trench-type semiconductor power device 100_2 shown in FIG. 10 along line B-B'. The trench-type semiconductor power device 100_2 is a double-trench-type semiconductor power device. Compared with the trench-type semiconductor power device 100_1 in FIG. 2, the trench-type semiconductor power device 100_2 further includes a shielding structure 111 surrounding the trench structures 110. The widths of the metal wires 210a and 210b in the Y direction are larger than the width of the metal wire 220a.

The shielding structure 111 is a comb-shaped trench structure, and consists of a plurality of trench structures extending in the Y direction (hereinafter referred to as first sub-shielding structures 111a) and one trench structure extending in the X direction (hereinafter referred to as second sub-shielding structure 111b). Each of the trench structures 110 is disposed between two adjacent first sub-shielding structures 111a, and the second sub-shielding structure 111b is disposed at an ESD protection structure ESD_P1 close to the trench structure 110, i.e., the second sub-shielding structure 111b is away from the source doped region 108. The shielding structure 111 has a depth D2 in the semiconductor material layer 103, and the depth D2 of the shielding structure 111 is greater than the depth D1 of the trench structures 110. The shielding structure 111 includes a semiconductor layer 122. The semiconductor layer 122 has a width W2 in the X direction and the width W2 is larger than the width W1. The semiconductor layer 122 has the same conductivity type doping as the lightly doped region 104, e.g., an N type. In addition, in the shielding structure 111, the semiconductor layer 122 is surrounded by the insulating layer 115.

In the trench-type semiconductor power device 100_2, similar to the trench-type semiconductor power device 100_1, each of the trench structures 110 includes one ESD protection structure ESD_P1. The ESD protection structure ESD_P1 is separated from the shielding structure 111 by means of the lightly doped region 104 and the body doped region 106. In some embodiments, the source doped region 108 of the trench-type semiconductor power device 100_2 is formed in the trench-type semiconductor power device 100_2, and only on the side of the conductive plug 152 adjacent to the trench structures 110. Heavily doped regions 135 and 137 are located in the semiconductor layer 122 and have the same conductivity type doping as the lightly doped region 104, such as the N type. Conductive plugs 165 and 167 extend in the Z direction penetrating through the interlayer dielectric layer 116 in order to electrically connect the semiconductor layer 122 to the metal wires 210a and 210b. As previously described, the metal wire 210b is connected to the source terminal S and the metal wire 210a by means of the interconnect structure 215. For ease of illustration, the conductive plugs 165 and 167 can be used as source connection structures.

In the embodiments of the trench-type semiconductor power device 100_2, the gate resistor 30 in FIG. 1 is formed from parallel connection of gate resistors Rg in all of the trench structures 110. The diode string 20 in FIG. 1 is formed from parallel connection of the diode strings 20_1 of all of the ESD protection structures ESD_P1. In the trench-type semiconductor power device 100_2, when the number of trench structures 110 is increased, the number of ESD protection structures ESD_P1 is also increased, and thus more ESD paths can be provided to the vertical power transistor 10, and thus ESD protection capability can be increased.

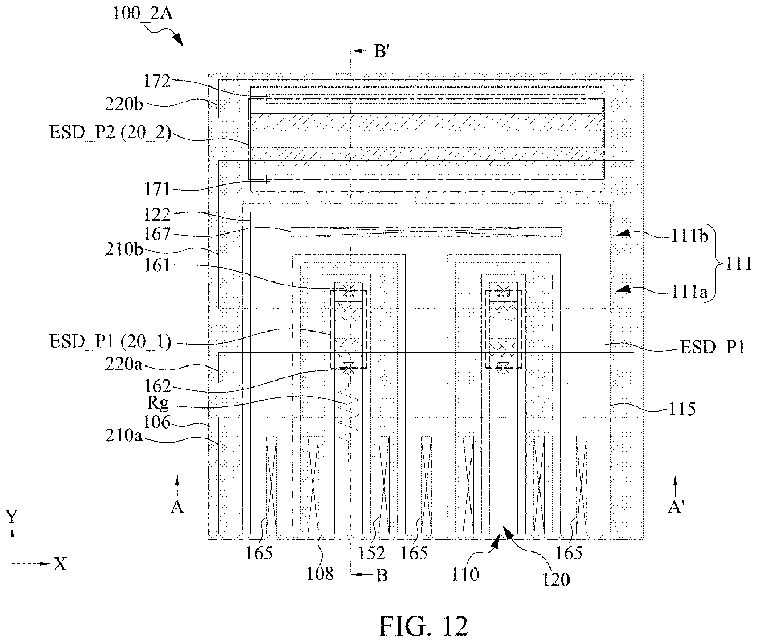

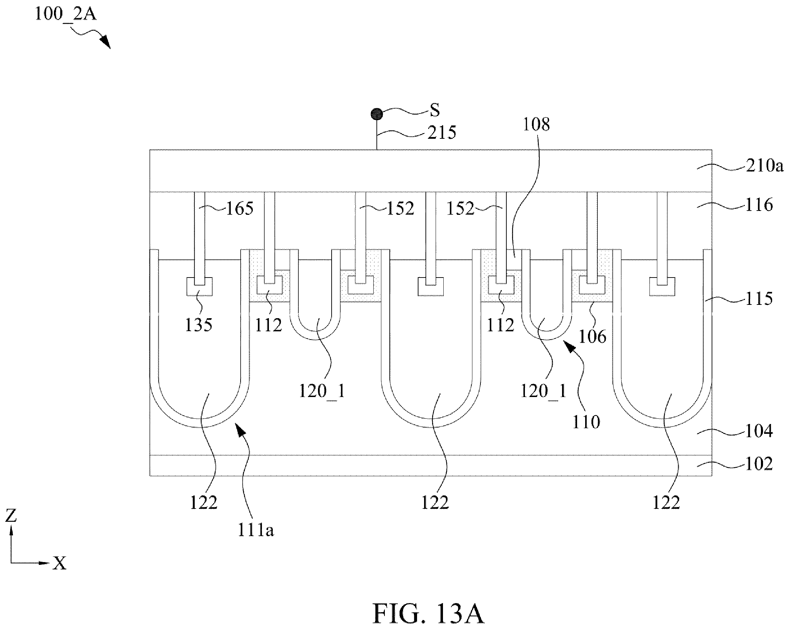

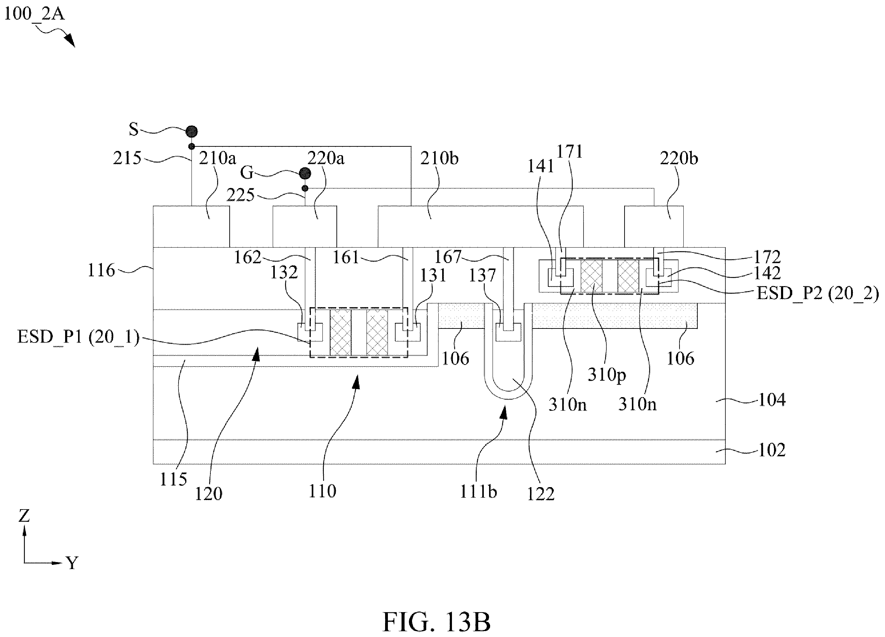

FIG. 12 is a top view of a trench-type semiconductor power device 100_2A according to some embodiments of the present disclosure. FIG. 13A is a cross-sectional view of the trench-type semiconductor power device 100_2A shown in FIG. 12 along line A-A' and FIG. 13B is a cross-sectional view of the trench-type semiconductor power device 100_2A shown in FIG. 12 along line B-B'. The trench-type semiconductor power device 100_2A is a double-trench-type semiconductor power device. The structure configuration of the trench-type semiconductor power device 100_2A in FIG. 12 is similar to that of the trench-type semiconductor power device 100_2 in FIG. 10, and the difference between the two power devices is that the trench-type semiconductor power device 100_2A further includes the ESD protection structure ESD_P2.

The ESD protection structure ESD_P2 includes the semiconductor layer 310 having a plurality of doped regions 310n and a plurality of doped regions 310p. In the trench-type semiconductor power device 100_2A, the ESD protection structure ESD _P2 is separated from the ESD protection structure ESD_P1 and surrounded by the interlayer dielectric layer 116. The shielding structure 111 is disposed between the ESD protection structure ESD_P2 and the ESD protection structure ESD_P1. Furthermore, the semiconductor layer 310 of the ESD protection structure ESD_P2 is formed above the semiconductor layer 120 and overlaps the body doped region 106. Accordingly, the depths of the conductive plugs 171 and 172 in the Z direction are less than those of the conductive plugs 161 and 162.

In the ESD protection structure ESD_P2, the first end (i.e., the doped region 120n distant from the ESD protection structure ESD_P1, or the doped region 310n provided with the heavily doped region 142) of the diode string 20_2 is electrically connected to the gate terminal G by means of a gate connection structure (e.g., the metal wire 220b, the interconnect structure 225, etc.), and the second end (i.e., the doped region 120n adjacent to the ESD protection structure ESD_P1, or the doped region 310n provided with the heavily doped region 141) of the diode string 20_2 is electrically connected to the source terminal S by means of a source connection structure (e.g., the metal wire 210b, the interconnect structure 215, etc.). In the embodiments of the trench-type semiconductor power device 100_2A, the diode string 20 in FIG. 1 is formed from parallel connection of the diode strings 20_1 of all of the ESD protection structures ESD_P1 and the diode string 20_2 of the ESD protection structure ESD_P2. In the trench-type semiconductor power device 100_2A, more ESD paths can be provided to the vertical power transistor 10 by using the additional ESD protection structure ESD_P2, and thus ESD protection capability can be increased. The ESD protection structure ESD _P2 of the trench-type semiconductor power device 100_2A is similar to the ESD protection structure ESD _P2 of the trench-type semiconductor power device 100_1A, and the difference between the two is that the trench-type semiconductor power device 100_2A is implemented by applying the ESD protection structure ESD_P2 to the double-trench-type semiconductor power device 100_2, and therefore for the detailed structure of the trench-type semiconductor power device 100_2A, reference can be made to the paragraph description of the trench-type semiconductor power device 100_1A and will not be repeated here.

In other embodiments, the ESD protection structure ESD_P2 of the trench-type semiconductor power device 100_2A and the ESD protection structure ESD_P1 are formed in the same horizontal plane in the Z direction and disposed in different trenches separated from each other, e.g., the ESD_P1 and the ESD_P2 shown in FIG. 9B.

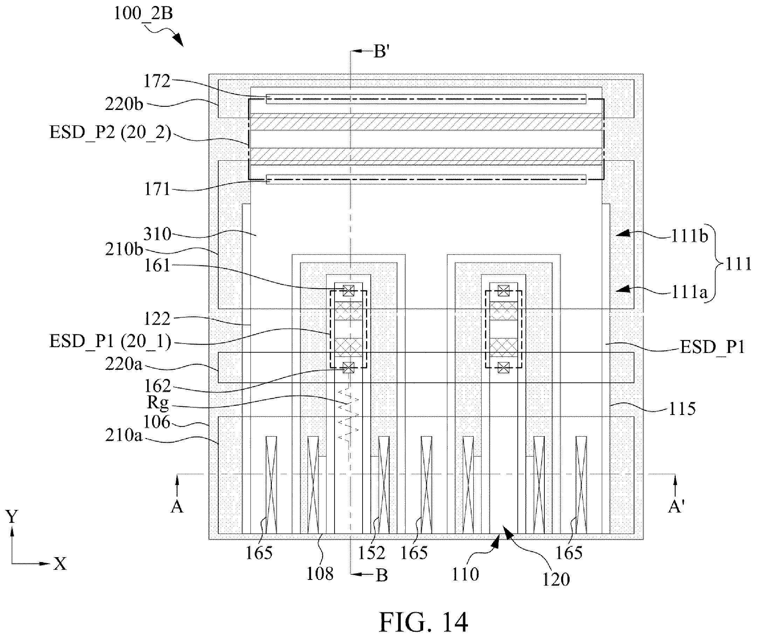

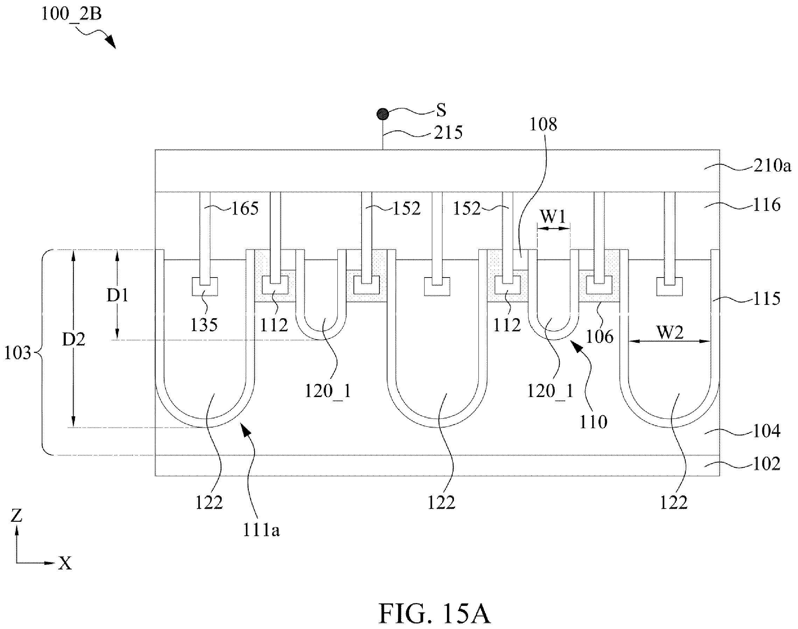

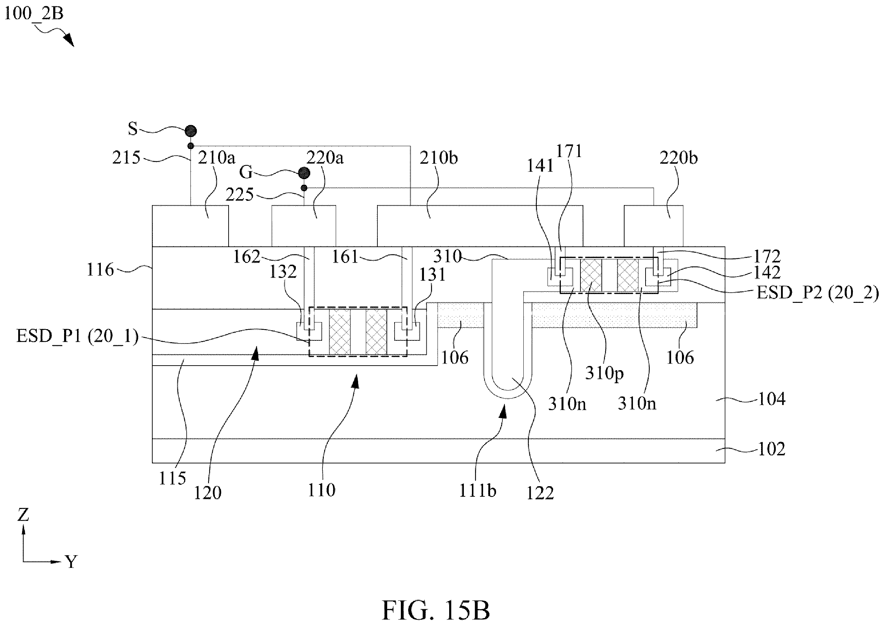

FIG. 14 is a top view of a trench-type semiconductor power device 100_2B according to some embodiments of the present disclosure. FIG. 15A is a cross-sectional view of the trench-type semiconductor power device 100_2B shown in FIG. 14 along line A-A', and FIG. 15B is a cross-sectional view of the trench-type semiconductor power device 100_2B shown in FIG. 14 along line B-B'. The trench-type semiconductor power device 100_2B is a double-trench-type semiconductor power device. The structure configuration of the trench-type semiconductor power device 100_2B of FIG. 14 is similar to that of the trench-type semiconductor power device 100_2A of FIG. 12, and the difference between the two power devices is that the ESD protection structure ESD_P2 and the shielding structure 111 of the trench-type semiconductor power device 100_2B are merged together by passing through the extended semiconductor layer 310.

In the trench-type semiconductor power device 100_2B, the semiconductor layer 310 forming the ESD protection structure ESD_P2 extends in the Y direction towards the shielding structure 111 to connect the semiconductor layer 122 of the second sub-shielding structure 111b extending in the Z direction, that is, the semiconductor layer 310 will abut against the semiconductor layer 122. The semiconductor layer 122 is electrically connected to the metal wire 210b by means of the heavily doped region 141 and the conductive plug 171.

The ESD protection structure of the present disclosure may be integrated with a gate structure to achieve the effects of reducing manufacturing costs and reducing product area. In other embodiments, the ESD protection structures of the present disclosure may be further integrated with a shielding electrode to achieve the effect of enhancing the effectiveness of ESD protection. Various exemplary embodiments in which the ESD protection structures are integrated with the shielding electrode are provided below, but the present disclosure is not limited thereto.

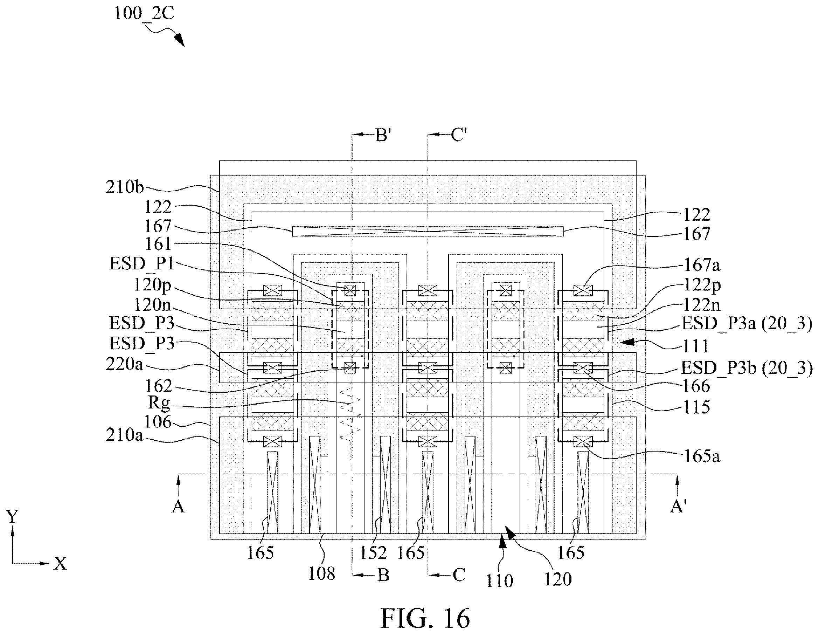

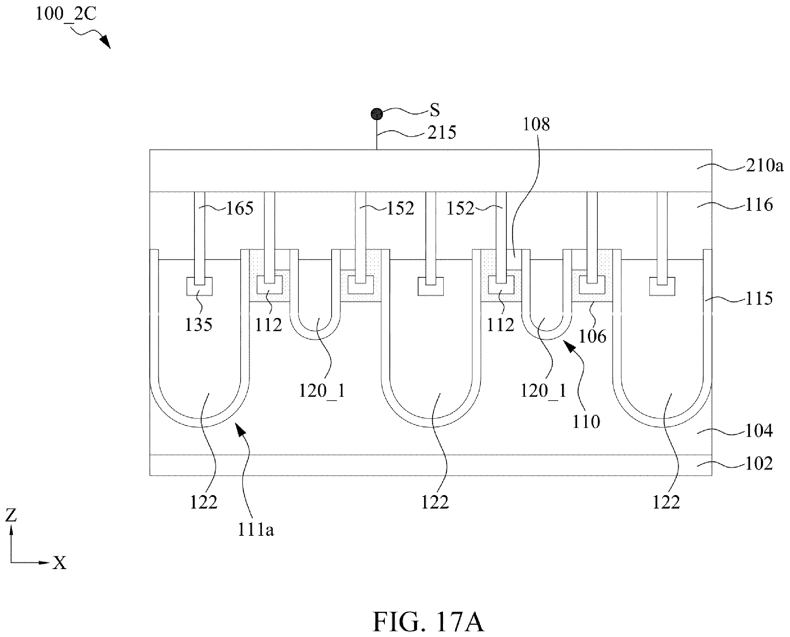

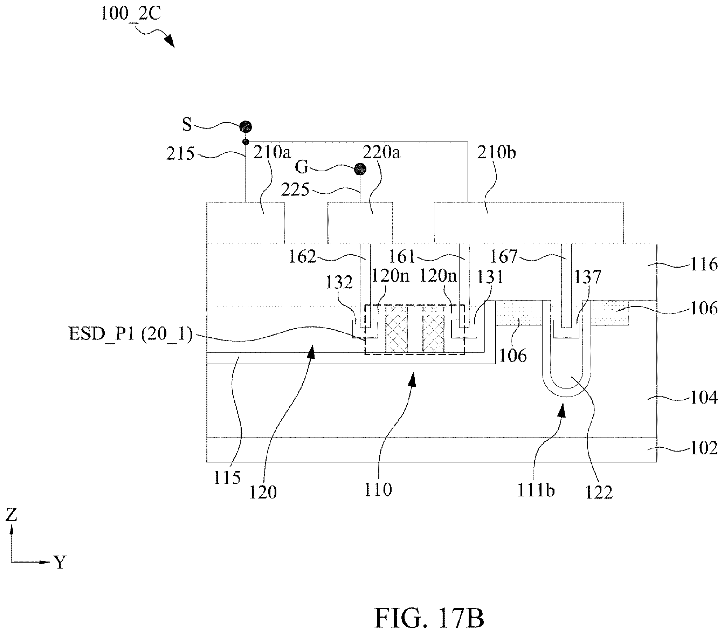

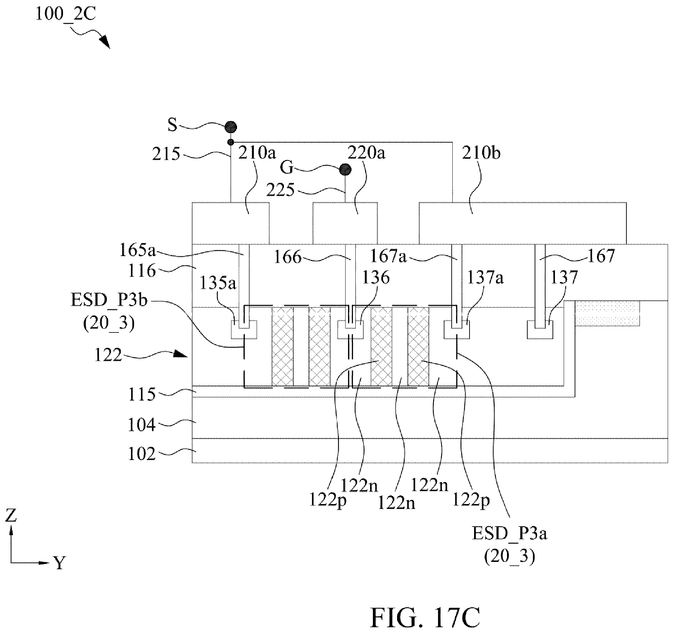

FIG. 16 is a top view of a trench-type semiconductor power device 100_2C according to some embodiments of the present disclosure. FIG. 17A is a cross-sectional view of the trench-type semiconductor power device 100_2C shown in FIG. 16 along line A-A', FIG. 17B is a cross-sectional view of the trench-type semiconductor power device 100_2C shown in FIG. 16 along line B-B', and FIG. 17C is a cross-sectional view of the trench-type semiconductor power device 100_2C shown in FIG. 16 along line C-C'. The trench-type semiconductor power device 100_2C is a double-trench-type semiconductor power device. The structure configuration of the trench-type semiconductor power device 100_2C of FIG. 16 is similar to that of the trench-type semiconductor power device 100_2 of FIG. 10, and the difference between the two power devices is that the shielding structure 111 of the trench-type semiconductor power device 100_2C further includes a plurality of ESD protection structures ESD_P3.

In the ESD protection structures ESD_P3, the semiconductor layer 122 of the first sub-shielding structures 111a is divided into the first partial semiconductor layer 122 away from the second sub-shielding structure 111b and the second partial semiconductor layer 122 close to the second sub-shielding structure 111b. In other words, the first partial semiconductor layer 122 is close to the source doped region 108, and the second sub-shielding structure 111b is distant from the source doped region 108. The first partial semiconductor layer 122 is completely covered with the metal wire 210a, and electrically connected to the metal wire 210a by means of the conductive plug 165. The first partial semiconductor layer 122 has the same conductivity type doping as the lightly doped region 104, e.g., the N type. The second partial semiconductor layer 122 includes the plurality of doped regions 122n and the plurality of doped regions 122p. The doped regions 122n and the doped regions 122p have different conductivity types. For example, the doped regions 122n have the same conductivity type doping as the doped regions 120n, e.g., the N type, and the doped regions 122p has the same conductivity type doping as the doped regions 120p, e.g., the P type. An interface between the doped regions 122n and the doped regions 122p will form a PN junction. Furthermore, each of the doped regions 122p and two of the doped regions 122n adjacent to said doped region 122p form one back-to-back diode (that is, the back-to-back diode 22 in FIG. 1) In the ESD protection structures ESD _P3, the doped regions 122n and the doped regions 122p are staggered to form a diode string (hereinafter collectively referred to as diode string 20_3) having two back-to-back diodes 22 connected in series. Furthermore, the number of the back-to-back diodes 22 in the diode string 20_3 is the same as that of the back-to-back diodes 22 in the diode string 20_1. The semiconductor layer 122 of each of the first sub-shielding structures 111a may include one or more ESD protection structures ESD_P3.

In the embodiments of the trench-type semiconductor power device 100_2C, the first sub-shielding structures 111a of the shielding structure 111 (i.e., a trench structure extending in the Y direction) includes two ESD protection structures ESD _P3, e.g., an ESD protection structure ESD _P3 disposed between the metal wires 210b and 220a (hereinafter collectively referred to as ESD protection structure ESD_P3a) and an ESD protection structure ESD_P3 disposed between the metal wires 210a and 220a (hereinafter collectively referred to as ESD protection structure ESD_P3b). In some embodiments, an ESD protection structure ESD_P1 is disposed between two ESD protection structures ESD_P3a, and a gate resistor Rg is disposed between two ESD protection structures ESD_P3b. In some embodiments, the first sub-shielding structures 111a of the shielding structure 111 includes only one ESD protection structure ESD _P3, e.g., an ESD protection structure ESD_P3a or ESD_P3b.

In the ESD protection structure ESD_P3a, the first end (i.e., the doped region 120n adjacent to the first partial semiconductor layer 122, or the doped region 122n provided with a heavily doped region 136) of the diode string 20_3 is electrically connected to a gate terminal G by means of a gate connection structure (e.g., a conductive plug 166, the metal wire 220a, the interconnect structure 225, etc.), and the second end (i.e., the doped region 120n away from the first partial semiconductor layer 122, or the doped region 122n provided with a heavily doped region 137a) of the diode string 20_3 is electrically connected to the source terminal S by means of a source connection structure (e.g., a conductive plug 167a, the metal wire 210b, the interconnect structure 215, etc.). In the ESD protection structure ESD_P3b, the first end (i.e., the doped region 120n distant from the first partial semiconductor layer 122, or the doped region 122n provided with the heavily doped region 136) of the diode string 20_3 is electrically connected to the gate terminal G by means of the gate connection structure (e.g., the conductive plug 166, the metal wire 220a, the interconnect structure 225, etc.), and the second end (i.e., the doped region 120n adjacent to the first partial semiconductor layer 122, or the doped region 122n provided with a heavily doped region 135a) of the diode string 20_3 is electrically connected to the source terminal S by means of the source connection structure (e.g., a conductive plug 165a, the metal wire 210a, the interconnect structure 215, etc.). In the embodiments of the trench-type semiconductor power device 100_2C, the diode string 20 in FIG. 1 is formed from parallel connection of the diode strings 20_1 of all of the ESD protection structures ESD_P1 and the diode strings 20_3 of all of the ESD protection structures ESD_P3, for example, formed from parallel connection of two diode strings 20_1 and six diode strings 20_3. In the trench-type semiconductor power device 100_2C, when the number of ESD protection structures ESD_P3 is increased, more ESD paths can be provided to the vertical power transistor 10, and thus ESD protection capability can be increased.

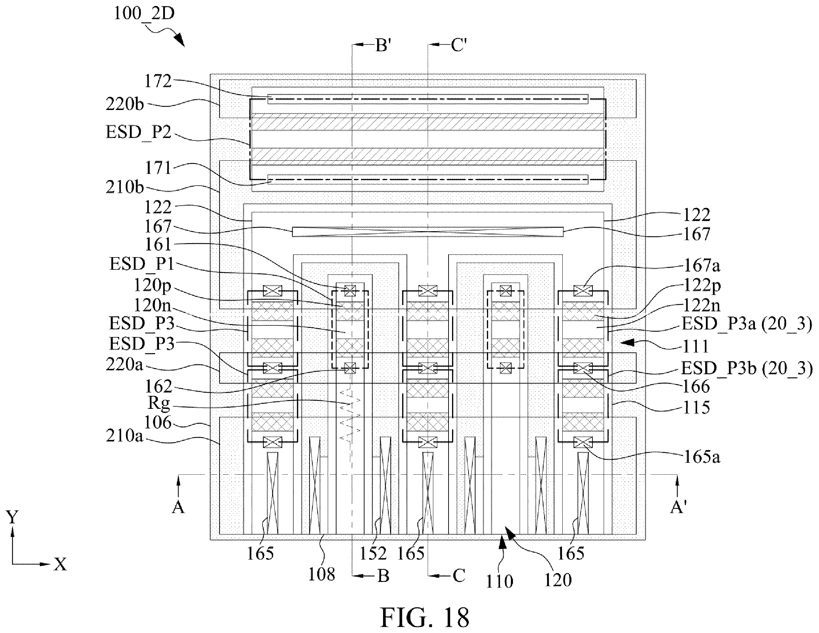

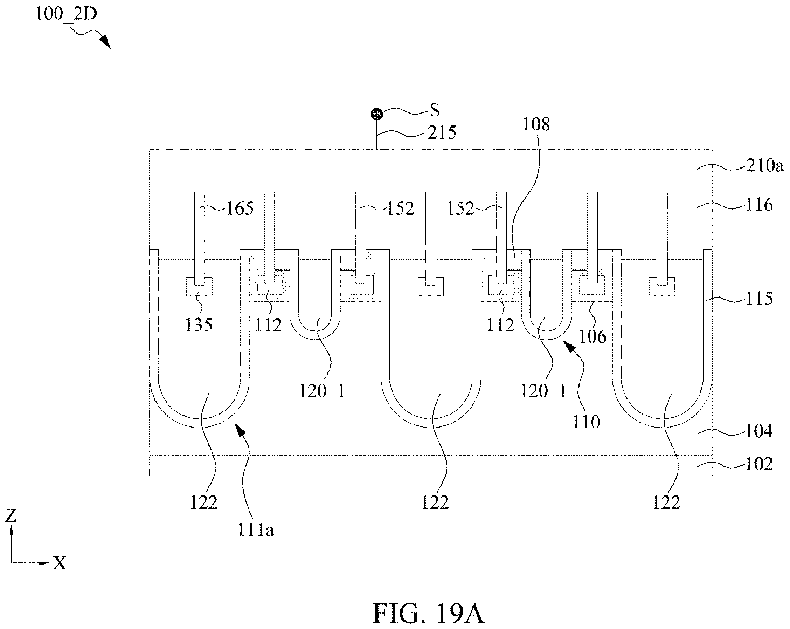

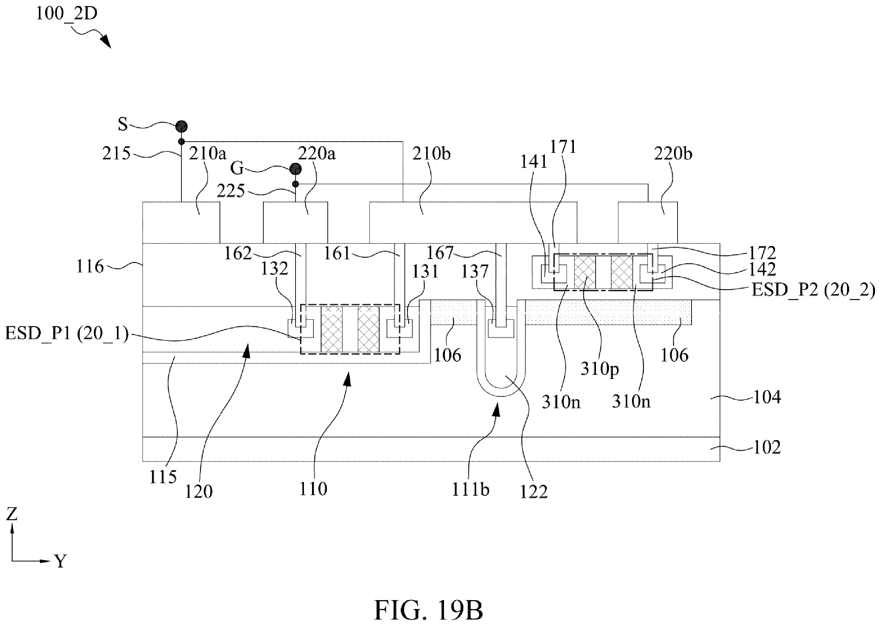

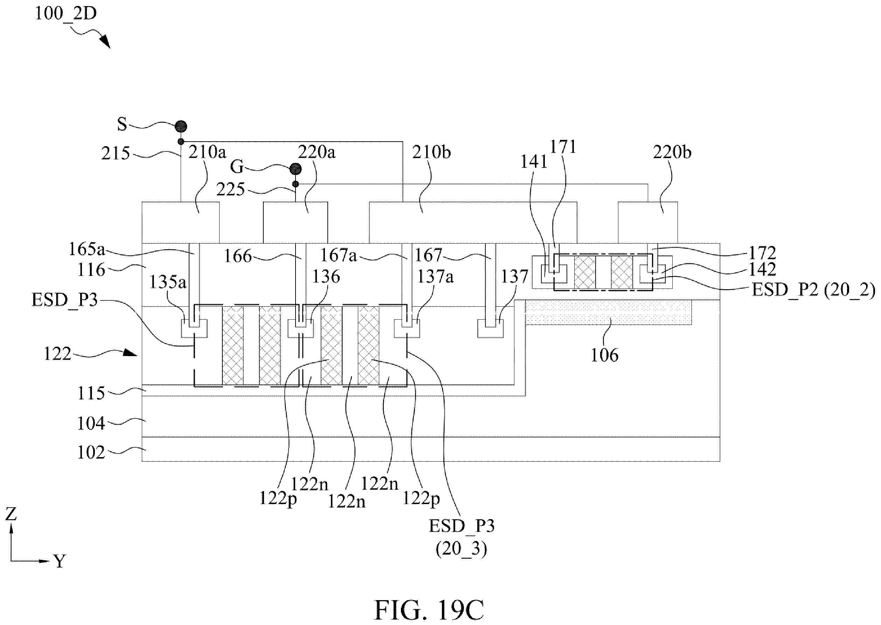

FIG. 18 is a top view of a trench-type semiconductor power device 100_2D according to some embodiments of the present disclosure. FIG. 19A is a cross-sectional view of the trench-type semiconductor power device 100_2D shown in FIG. 18 along line A-A', FIG. 19B is a cross-sectional view of the trench-type semiconductor power device 100_2D shown in FIG. 18 along line B-B', and FIG. 19C is a cross-sectional view of the trench-type semiconductor power device 100_2D shown in FIG. 18 along line C-C'. The trench-type semiconductor power device 100_2D is a double-trench-type semiconductor power device. The structure configuration of the trench-type semiconductor power device 100_2D of FIG. 18 is similar to that of the trench-type semiconductor power device 100_2C of FIG. 16, and the difference between the two power devices is that the trench-type semiconductor power device 100_2D further includes the ESD protection structure ESD_P2.

In the trench-type semiconductor power device 100_2D, the ESD protection structure ESD _P2 is separated from ESD protection structures ESD_P1 and ESD_P3, and surrounded by the interlayer dielectric layer 116. Furthermore, the second sub-shielding structure 111b of the shielding structure 111 (i.e., a trench structure extending in the X direction) is disposed between the ESD protection structure ESD_P2 and the ESD protection structure ESD_P1 (or the ESD protection structure ESD_P3a). The semiconductor layer 310 of the ESD protection structure ESD _P2 is formed above the semiconductor layer 120 and overlaps the body doping region 106. Accordingly, the depths of the conductive plugs 171 and 172 in the Z direction are less than those of the conductive plugs 161, 162, 165a, 166, 167, and 167a.

In the ESD protection structure ESD_P2, the first end (i.e., the doped region 120n distant from the ESD protection structure ESD_P1, or the doped region 310n provided with a heavily doped region 142) of the diode string 20_2 is electrically connected to the gate terminal G by means of a gate connection structure (e.g., the metal wire 220b, the interconnect structure 225, etc.), and the second end (i.e., the doped region 120n adjacent to the ESD protection structure ESD_P1, or the doped region 310n provided with the heavily doped region 141) of the diode string 20_2 is electrically connected to the source terminal S by means of a source connection structure (e.g., the metal wire 210b, the interconnect structure 215, etc.). In the embodiments of the trench-type semiconductor power device 100_2D, the diode string 20 in FIG. 1 is formed from parallel connection of the diode strings 20_1 of all of the ESD protection structures ESD_P1, the diode strings 20_3 of all of the ESD protection structures ESD_P3 and the diode string 20_2 of the ESD protection structure ESD_P2. In the trench-type semiconductor power device 100_2D, more ESD paths can be provided to the vertical power transistor 10 by using the additional ESD protection structure ESD_P2, and thus ESD protection capability can be increased.

In some embodiments, the ESD protection structure ESD_P2 of the trench-type semiconductor power device 100_2D and the ESD protection structure ESD_P1 are formed in the same horizontal plane in the Z direction and disposed in different trenches separated from each other. In some embodiments, the ESD protection structure ESD_P2 of the trench-type semiconductor power device 100_2D and the ESD protection structure ESD_P3 are formed in the same horizontal plane in the Z direction and disposed in different trenches separated from each other.

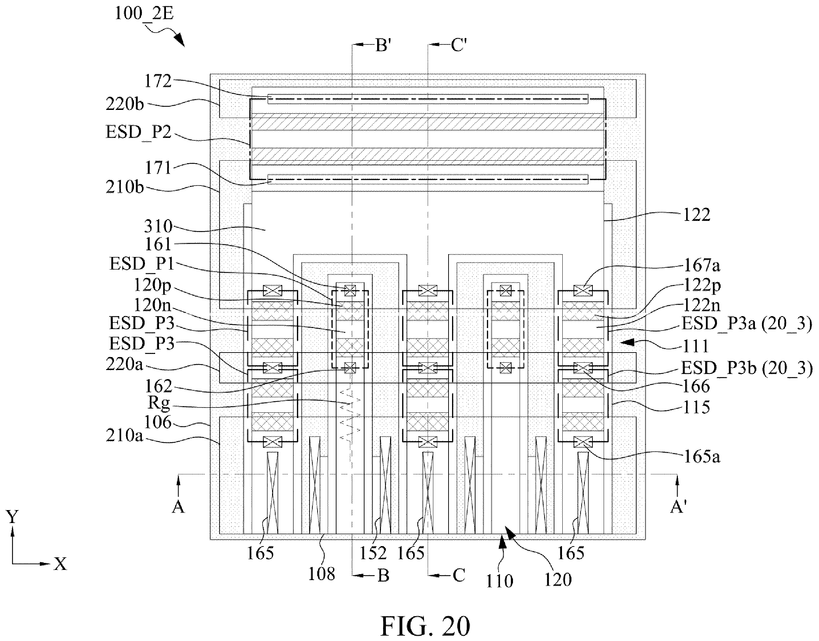

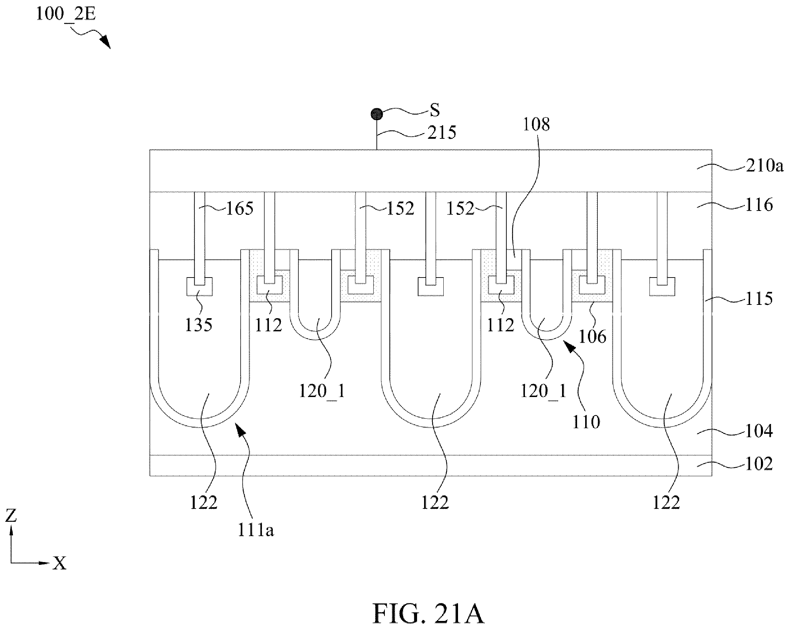

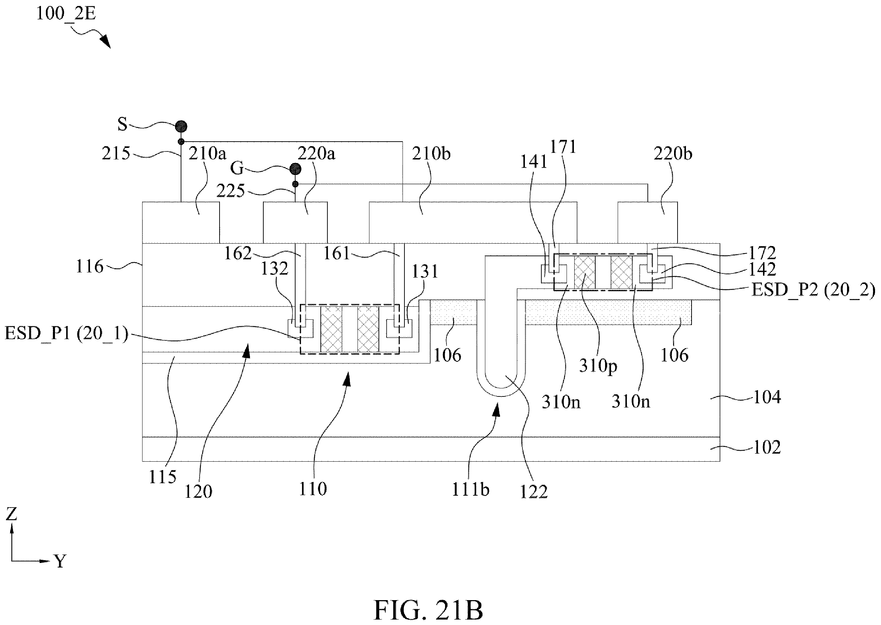

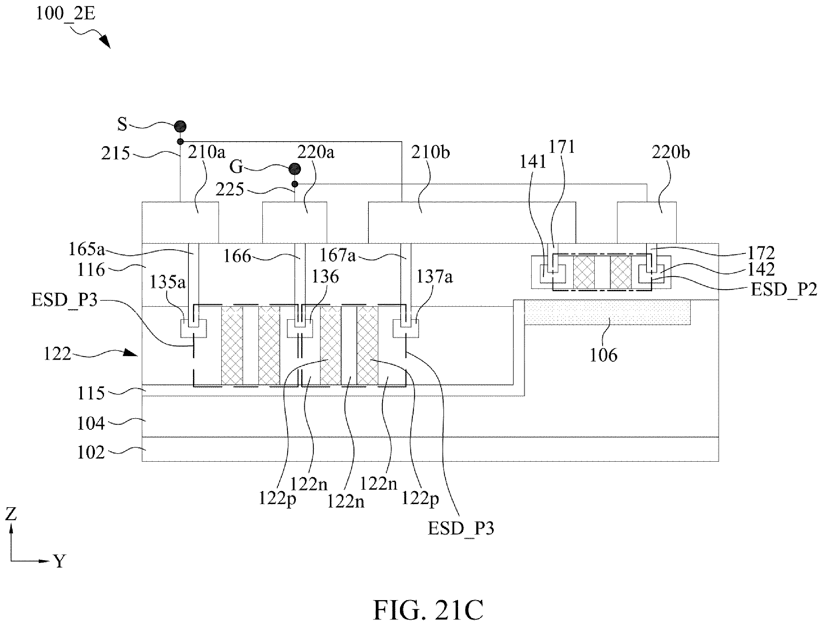

FIG. 20 is a top view of a trench-type semiconductor power device 100_2E according to some embodiments of the present disclosure. FIG. 21A is a cross-sectional view of the trench-type semiconductor power device 100_2E shown in FIG. 20 along line A-A', FIG. 21B is a cross-sectional view of the trench-type semiconductor power device 100_2E shown in FIG. 20 along line B-B', and FIG. 21C is a cross-sectional view of the trench-type semiconductor power device 100_2E shown in FIG. 20 along line C-C'. The trench-type semiconductor power device 100_2E is a double-trench-type semiconductor power device. The structure configuration of the trench-type semiconductor power device 100_2E in FIG. 20 is similar to that of the trench-type semiconductor power device 100_2D in FIG. 18, and the difference between the two power devices is that the ESD protection structure ESD_P2 and the shielding structure 111 of the trench-type semiconductor power device 100_2E are merged together by passing through the extended semiconductor layer 310.

In the trench-type semiconductor power device 100_2E, the semiconductor layer 310 forming the ESD protection structure ESD_P2 extends in the Y direction towards the shielding structure 111 to connect the' semiconductor layer 122 in the second sub-shielding structure 111b extending in the Z direction, that is, the semiconductor layer 310 will abut against the semiconductor layer 122. The semiconductor layer 122 of the second sub-shielding structure 111b is electrically connected to the metal wire 210b by means of the heavily doped region 141 and the conductive plug 171.

Several embodiments in which the ESD protection structures are integrated with the gate structure and/or the shielding electrode structure are provided above, which illustrates that the present disclosure may be broadly applied to various types of trench-type semiconductor power devices. Various embodiments in which the ESD protection structures are integrated into the gate structure and/or the shielding electrode structure of a split gate (SGT) semiconductor devices are provided below as an exemplary description, but the present disclosure is not limited thereto.

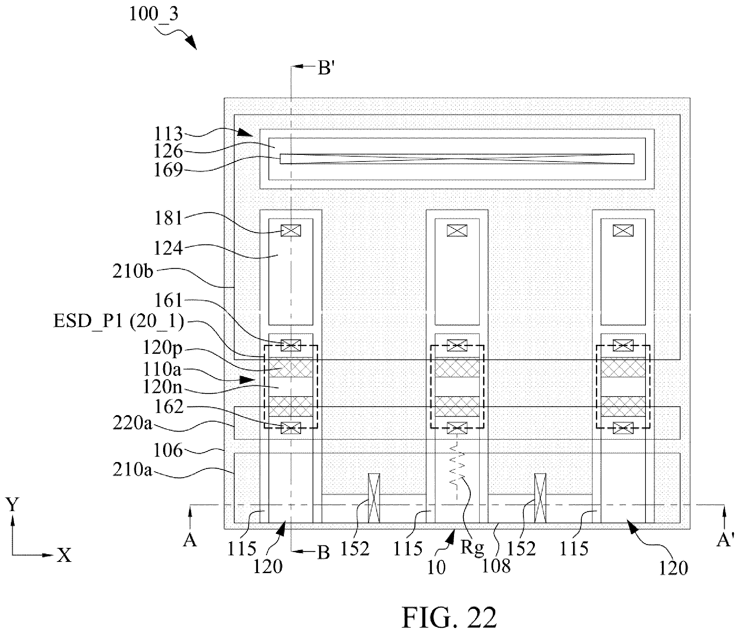

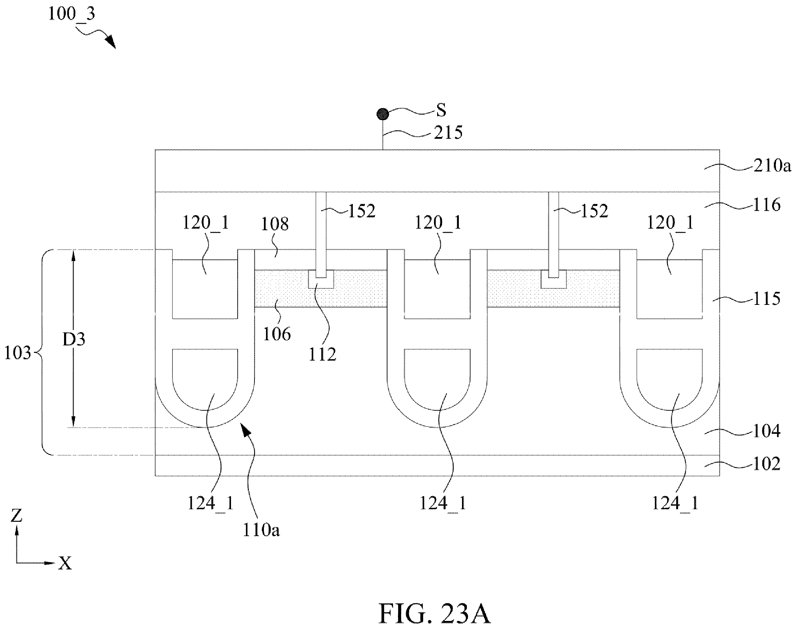

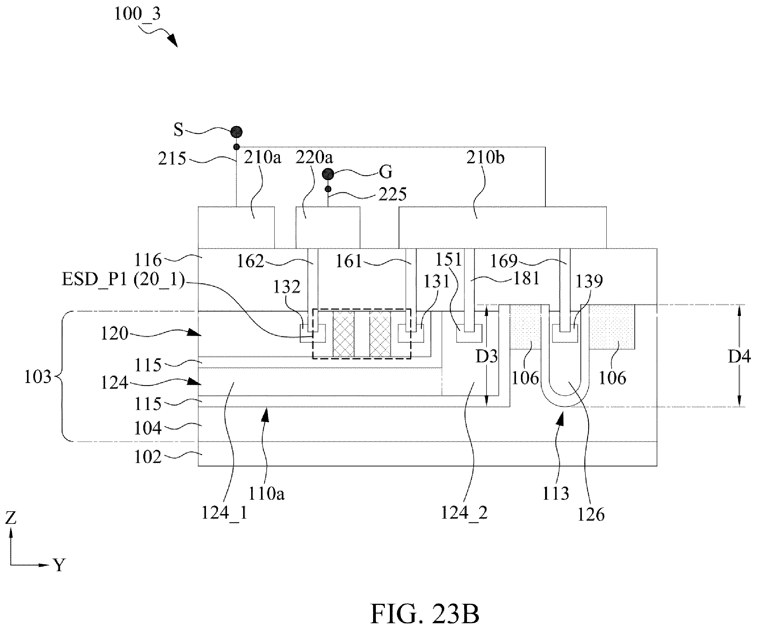

FIG. 22 is a top view of a trench-type semiconductor power device 100_3 according to some embodiments of the present disclosure. FIG. 23A is a cross-sectional view of the trench-type semiconductor power device 100_3 shown in FIG. 22 along line A-A', and FIG. 23B is a cross-sectional view of the trench-type semiconductor power device 100_3 shown in FIG. 22 along line B-B'. The trench-type semiconductor power device 100_2 is a trench-type split gate (SGT) semiconductor power device. Compared with the trench structures 110 of the trench-type semiconductor power device 100_1 in FIG. 2, a trench structure 110a of the trench-type semiconductor power device 100_3 further includes a semiconductor layer 124. In addition, compared with the trench-type semiconductor power device 100_1 in FIG. 2, the trench-type semiconductor power device 100_3 further includes a shielding structure 113. The widths of the metal wires 210a and 210b in the Y direction are greater than the width of the metal wire 220a, and the metal wire 210b has the largest width.

In the embodiments of the trench-type semiconductor power device 100_3, the shielding structure 113 has a depth D3 in a semiconductor material layer 103, and the shielding structure 113 extends in the Y direction. In some embodiments, the depth D3 of the shielding structure 113 is greater than the depth D1 of the trench structure 110. Furthermore, the shielding structure 113 has a depth D4 in the semiconductor material layer 103, and the shielding structure 113 extends in the X direction. In some embodiments, the depth D3 is equal to the depth D4. In some embodiments, the depth D3 is different from the depth D4. The shielding structure 113 includes a semiconductor layer 126. The semiconductor layer 126 has the same conductivity type doping as the lightly doped region 104, e.g., N-type. In some embodiments, the doping concentration of the semiconductor layer 126 is greater than that of the lightly doped region 104. Furthermore, in the shielding structure 113, the semiconductor layer 126 is surrounded by the insulating layer 115. The shielding structure 113 is separated from the trench structure 110a by passing through the lightly doped region 104 and the body doped region 106.

In the trench structure 110a, the semiconductor layer 124 is separated from a semiconductor layer 120 and surrounded by the insulating layer 115. The semiconductor layer 124 has the same conductivity type doping as the lightly doped region 104, e.g., N-type. In some embodiments, the doping concentration of the semiconductor layer 124 is greater than that of the lightly doped region 104. The semiconductor layer 124 can be divided into two parts 124_1 and 124_2 (hereinafter referred to as first partial semiconductor layer 124_1 and second partial semiconductor layer 124_2, respectively). The first partial semiconductor layer 124_1 extends in the Y direction and is disposed between the semiconductor layer 120 and the lightly doped region 104. The second partial semiconductor layer 124_2 extends in the Z direction and is disposed between the ESD protection structure ESD_P1 and the body doped region 106 (or the shielding structure 113). In the Z direction, the first partial semiconductor layer 124_1 overlaps the semiconductor layer 120, and the second partial semiconductor layer 124_2 does not overlap the semiconductor layer 120. Furthermore, in the Z direction, the thickness of the first partial semiconductor layer 124_1 and the thickness of the semiconductor layer 120 are less than the depth D3.

A heavily doped region 151 is located in the second partial semiconductor layer 124_2 and surrounds one end of a conductive plug 181. The conductive plug 181 extends in the Z direction through the interlayer dielectric layer 116 to connect the metal wire 210b and the second partial semiconductor layer 124_2. A heavily doped region 139 is located in the semiconductor layer 126 and surrounds one end of a conductive plug 169. The conductive plug 169 extends in the Z direction through the interlayer dielectric layer 116 to connect the metal wire 210b and the semiconductor layer 126. The heavily doped regions 151 and 139 have the same conductivity type as the lightly doped region 104, e.g., the N type. In the trench-type semiconductor power device 100_3, the semiconductor layer 124 and the semiconductor layer 126 are connected to the source terminal S by means of a source connection structure (e.g., the metal wire 210b, the interconnect structure 215, etc.).

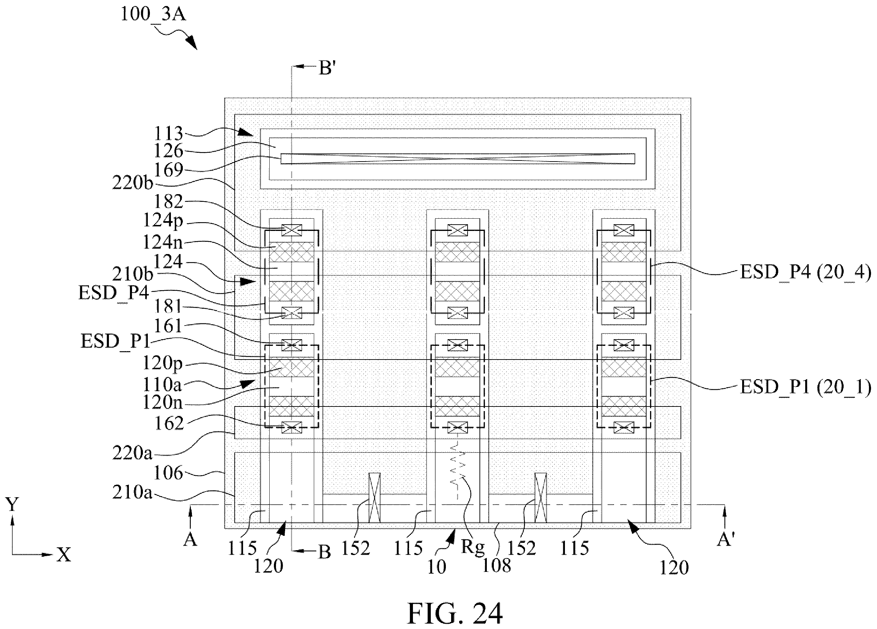

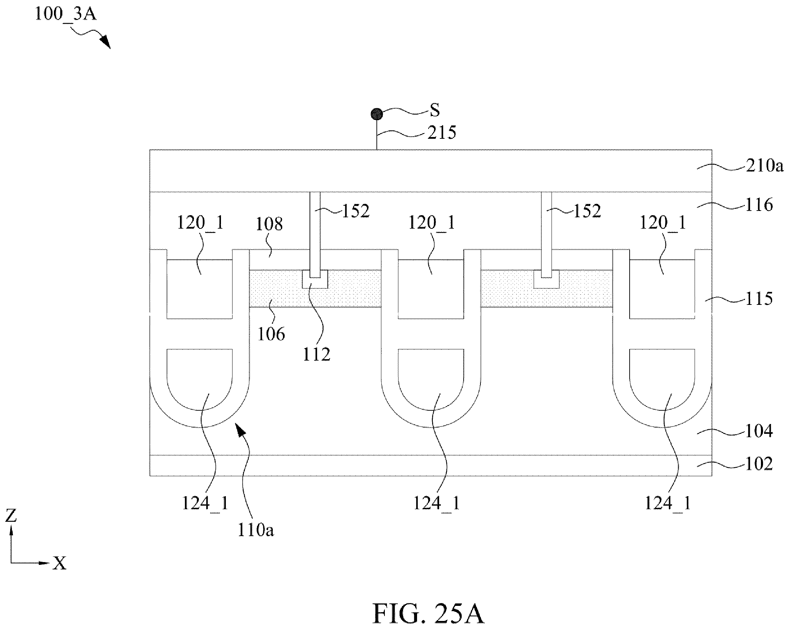

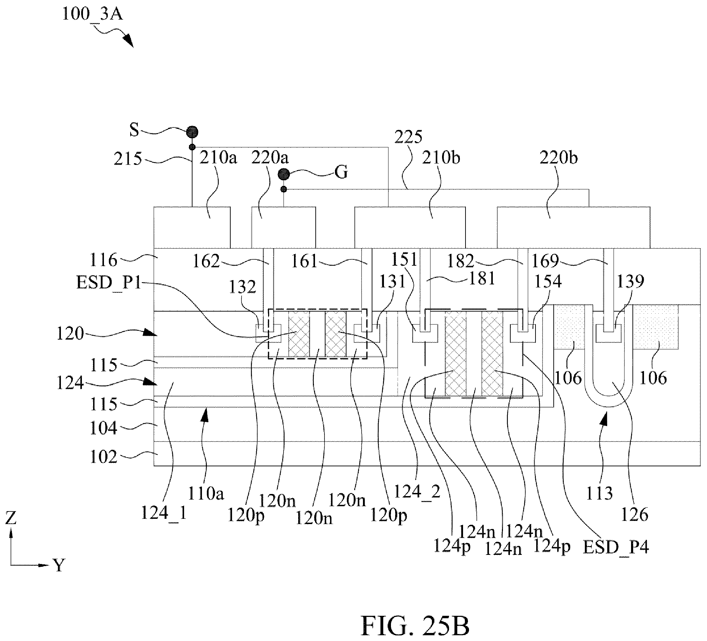

FIG. 24 is a top view of a trench-type semiconductor power device 100_3A according to some embodiments of the present disclosure. FIG. 25A is a cross-sectional view of the trench-type semiconductor power device 100_3A shown in FIG. 24 along line A-A', and FIG. 13B is a cross-sectional view of the trench-type semiconductor power device 100_3A shown in FIG. 12 along line B-B'. The trench-type semiconductor power device 100_3A is a trench-type SGT semiconductor power device. The structure configuration of the trench-type semiconductor power device 100_3A in FIG. 24 is similar to that of the trench-type semiconductor power device 100_3 in FIG. 22, and the difference between the two power devices is that the trench-type semiconductor power device 100_3A further includes ESD protection structures ESD_P4.

The ESD protection structures ESD_P4 are formed in the second partial semiconductor layer 124_2 of each of the trench structures 110a. Each of the ESD protection structures ESD_P4 includes a plurality of doped regions 124n and a plurality of doped regions 124p. The doped regions 124n and the doped regions 124p have different conductivity types. For example, the doped regions 124n have the same conductivity type doping as the doped regions 120n, e.g., the N type, and the doped regions 124p has the same conductivity type doping as the doped regions 120p, e.g., the P type. An interface between the doped regions 124n and the doped regions 124p will form a PN junction. Furthermore, each of the doped regions 124p and two of the doped regions 124n adjacent to the doped region 120p form a back-to-back diode 22. In the ESD protection structures ESD_P4, the doped regions 124n and the doped regions 124p are staggered to form a diode string having two back-to-back diodes 22 connected in series (hereinafter collectively referred to as diode string 20_4). Furthermore, the number of back-to-back diodes 22 in the diode string 20_4 is the same as that of the back-to-back diodes 22 in the diode string 20_1.

In some embodiments, the doped regions 124n and 120n have the same length L3 in the Y direction, and the doped regions 124p and 120p have the same length L2 in the Y direction. Furthermore, in the Z direction, the depths of the doped regions 124n and 124p are greater than the depths of the doped regions 120n and 120p.

A heavily doped region 151 is located in the doped region 124n at the frontmost end (e.g., abutting against the first partial semiconductor layer 124_1) of the second partial semiconductor layer 124_2, and surrounds one end of the conductive plug 181. The conductive plug 181 extends in the Z direction through the interlayer dielectric layer 116 to connect the metal wire 210b and the doped region 124n at the frontmost end. A heavily doped region 154 is located in the doped region 124n at the rearmost end (e.g., away from the first partial semiconductor layer 124_1) of the second partial semiconductor layer 124_2, and surrounds one end of the conductive plug 182. The conductive plug 182 extends in the Z direction through the interlayer dielectric layer 116 to connect the metal wire 220b and the doped region 124n at the rearmost end. The heavily doped regions 151 and 154 have the same conductivity type as the doped regions 120n, e.g., the N type. The metal wire 210b is connected to the source terminal S and the metal wire 210a by means of the interconnect structure 215.

In the ESD protection structures ESD_P4, the first end (i.e., the doped region 124n away from an ESD protection structure ESD _P1, or the doped region 124n provided with the heavily doped region 154) of the diode string 20_4 is electrically connected to the gate terminal G by means of a gate connection structure (e.g., the metal wire 220b, the interconnect structure 225, etc.), and the second end (i.e., the doped region 124n adjacent to the ESD protection structure ESD_P1, or the doped region 124n provided with the heavily doped region 151) of the diode string 20_4 is electrically connected to the source terminal S by means of a source connection structure (e.g., the metal wire 210b, the interconnect structure 215, etc.). The ESD protection structures ESD_P1 and ESD_P4 partially overlap the metal wire 210b. The metal wire 210b is connected to the doped region 120n of the ESD protection structure ESD_P1 by means of the conductive plug 161 and to the doped region 124n of the ESD protection structure ESD_P4 by means of the conductive plug 181. In each of the shielding structures 110a, the ESD protection structure ESD_P1 may be connected in parallel with the ESD protection structure ESD_P4 through the source connection structure (e.g., associated metal wires and conductive plugs connected to the interconnect structure 215) and the gate connection structure (e.g., associated metal wires and conductive plugs connected to the interconnect structure 225). In other words, in the embodiments of the trench-type semiconductor power device 100_3A, a diode string 20 in FIG. 1 is formed from parallel connection of the diode strings 20_1 of all of the ESD protection structures ESD_P1 and the diode strings 20_4 of all of the ESD protection structures ESD_P4. In some embodiments, the number of the ESD protection structures ESD_P1 is the same as the number of the ESD protection structures ESD_P4. In the trench-type semiconductor power device 100_3A, more ESD paths can be provided to the vertical power transistor 10 by using the additional ESD protection structures ESD_P4, and thus ESD protection capability can be increased.

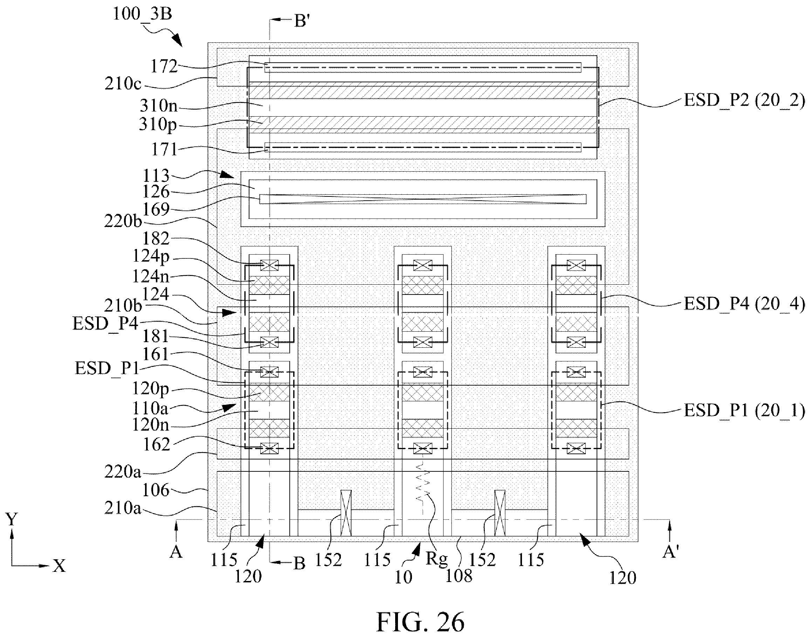

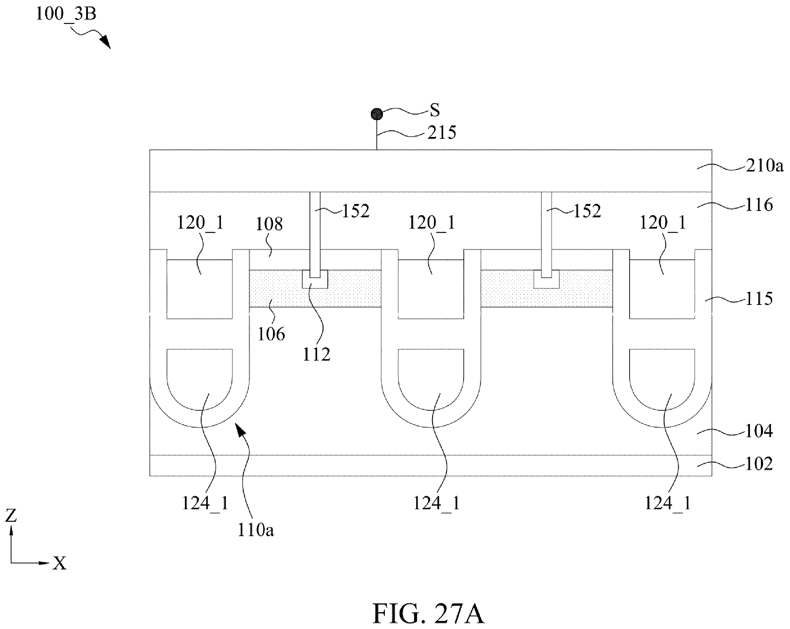

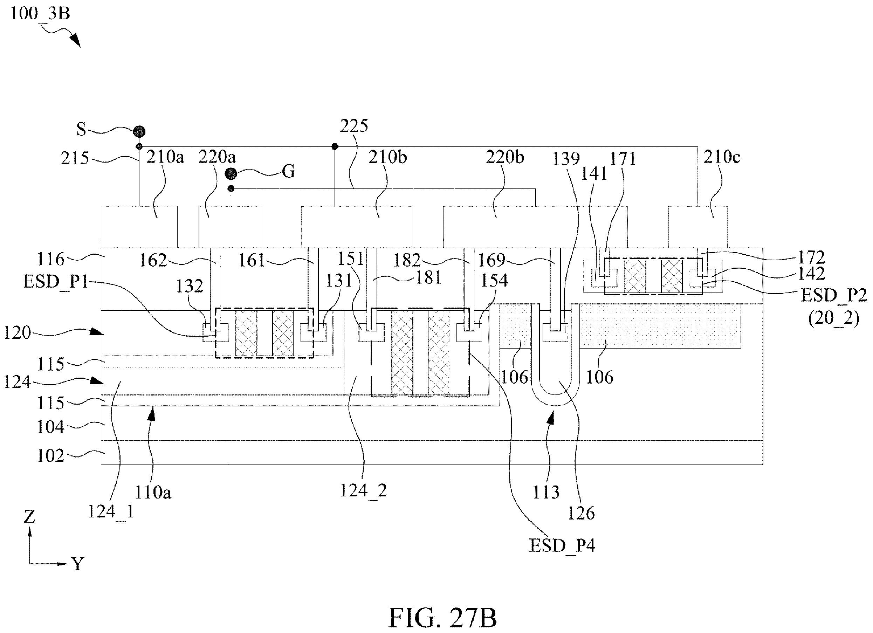

FIG. 26 is a top view of a trench-type semiconductor power device 100_3B according to some embodiments of the present disclosure. FIG. 27A is a cross-sectional view of the trench-type semiconductor power device 100_30 shown in FIG. 26 along line A-A', and FIG. 27B is a cross-sectional view of the trench-type semiconductor power device 100_3B shown in FIG. 26 along line B-B'. The trench-type semiconductor power device 100_3B is a trench-type SGT semiconductor power device. The structure configuration of the trench-type semiconductor power device 100_3B in FIG. 26 is similar to that of the trench-type semiconductor power device 100_3A in FIG. 24, and the difference between the two power devices is that the trench-type semiconductor power device 100_3B further includes an ESD protection structure ESD_P2.

In the trench-type semiconductor power device 100_3B, the ESD protection structure ESD _P2 is separated from an ESD protection structure ESD_P1 and an ESD protection structure ESD_P4, and surrounded by the interlayer dielectric layer 116. The shielding structure 113 is disposed between the ESD protection structure ESD_P2 and the ESD protection structure ESD_P4. Furthermore, the ESD protection structure ESD _P2 is formed above the semiconductor layer 120 and overlaps the body doped region 106.

In the ESD protection structure ESD _P2, the first end (i.e., a doped region 120n adjacent to the ESD protection structure ESD_P1, or a doped region 310n provided with a heavily doped region 141) of the diode string 20_2 is electrically connected to the gate terminal G by means of a gate connection structure (e.g., the conductive plug 171, the metal wire 220b, the interconnect structure 225, etc.), and the second end (i.e., a doped region 120n distant from the ESD protection structure ESD_P1, or a doped region 310n provided with a heavily doped region 142) of the diode string 20_2 is electrically connected to the source terminal S by means of a source connection structure (e.g., the conductive plug 172, the metal wire 210c, the interconnect structure 215, etc.). In the embodiments of the trench-type semiconductor power device 100_3A, the diode string 20 in FIG. 1 is formed from parallel connection of diode strings 20_1 of all of the ESD protection structures ESD_P1, diode strings 20_4 of all of the ESD protection structures ESD_P4 and the diode string 20_2 of the ESD protection structure ESD_P2. In the trench-type semiconductor power device 100_3B, more ESD paths can be provided to the vertical power transistor 10 by using the additional ESD protection structure ESD_P2, and thus the capability of ESD protection can be increased.

In some embodiments, the ESD protection structure ESD_P2 of the trench-type semiconductor power device 100_3B and the ESD protection structure ESD_P1 or the ESD protection structure ESD_P4 are formed in the same horizontal plane in the Z direction and disposed in different trenches separated from each other.

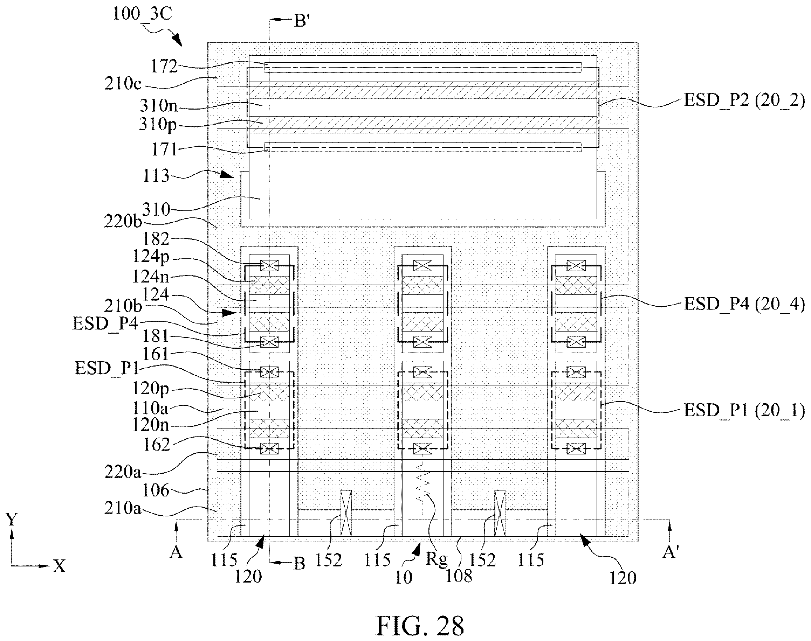

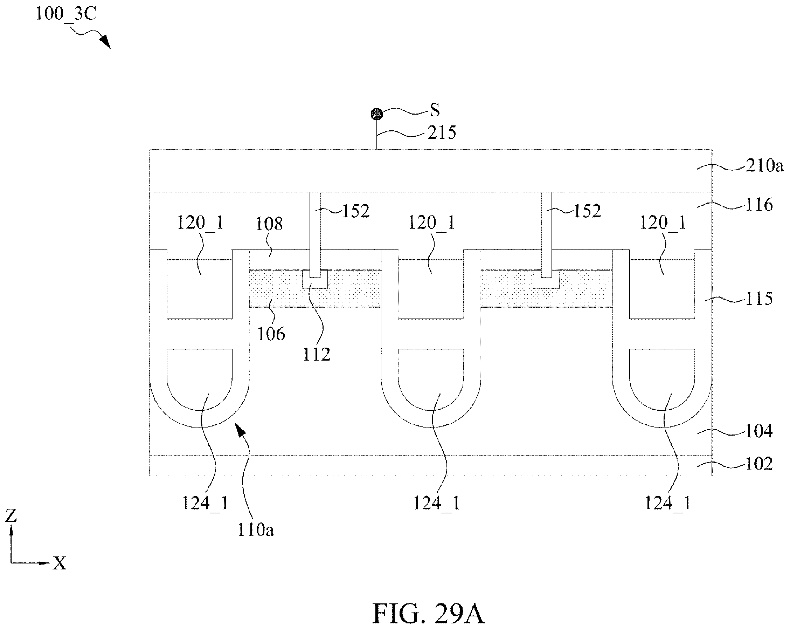

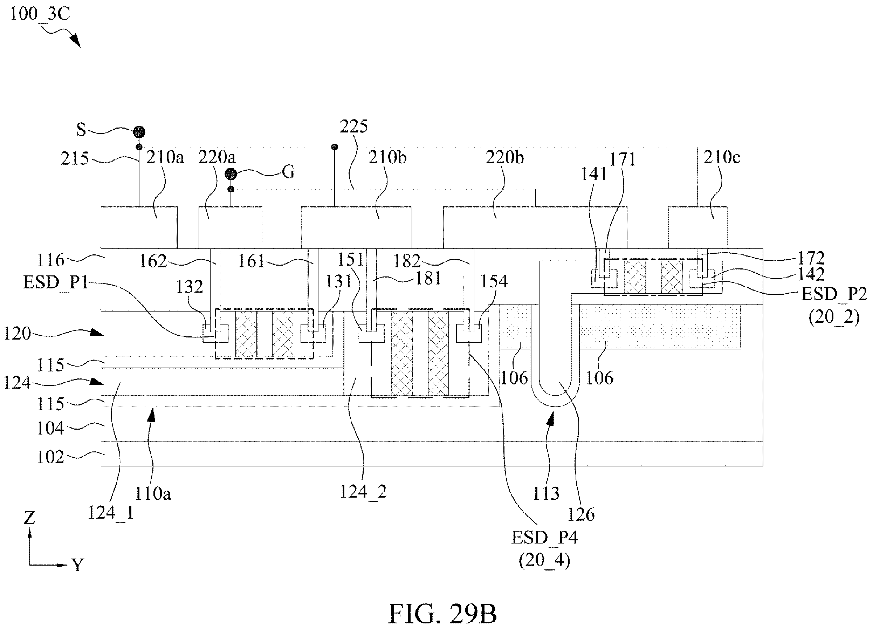

FIG. 28 is a top view of a trench-type semiconductor power device 100_3C according to some embodiments of the present disclosure. FIG. 29A is a cross-sectional view of the trench-type semiconductor power device 100_3C shown in FIG. 28 along line A-A', and FIG. 29B is a cross-sectional view of the trench-type semiconductor power device 100_3C shown in FIG. 28 along line B-B'. The trench-type semiconductor power device 100_3C is a trench-type SGT semiconductor power device. The structure configuration of the trench-type semiconductor power device 100_3C in FIG. 28 is similar to that of the trench-type semiconductor power device 100_3B in FIG. 26, the difference between the two power devices being that an ESD protection structure ESD_P2 and the shielding structure 113 of the trench-type semiconductor power device 100_3C are merged together by passing through the extended semiconductor layer 310.

In the trench-type semiconductor power device 100_3C, the semiconductor layer 310 forming the ESD protection structure ESD_P2 extends in the Y direction towards the shielding structure 113 to connect a semiconductor layer 126 extending in the Z direction, that is, the semiconductor layer 310 will abut against the semiconductor layer 126. The semiconductor layer 126 is electrically connected to the metal wire 220b by means of the heavily doped region 141 and the conductive plug 171.

Herein, for convenience of description, spatially relative terms such as "below," "under," "lower," "above," "upper," "left side," and "right side" may be used to describe the relationship between one component or feature and another or more components or features as shown in the accompanying drawings. In addition to the orientation depicted in the accompanying drawings, the spatially relative terms may be intended to encompass different orientations of a device in use or operation. The apparatus may be otherwise oriented (by rotating 90 degrees or at other orientations) and similarly, spatially relative descriptors used herein may be interpreted in a corresponding manner. It should be understood that when a component is referred to as "connected to" or "coupled to" another component, it may be directly connected to or coupled to another component, or an intermediate component may be present.

As used herein, the terms "approximately," "substantially," "essentially," and "about" are used to describe and interpret small variations. When used in conjunction with an event or circumstance, the terms can refer to instances where the event or circumstance occurs exactly as well as instances where the event or circumstance occurs nearly. As used herein with respect to a given value or range, the term "about" refers generally to within ± 10%, ± 5%, ± 1%, or ± 0.5% of a given value or range. The range may be expressed herein as one endpoint to another endpoint or between two endpoints. All ranges disclosed herein include endpoints unless otherwise specified. The term "substantially coplanar" may refer to the difference in position of two surfaces positioned along the same plane being within several microns (µm), such as the difference in locating position along the same plane being within 10 µm, 5 µm, 1 µm or 0.5 µm. When values or properties are referred to as being "substantially" identical, the term may refer to values that are within ±10%, ±5%, ±1%, or ±0.5% of the mean value of the stated values.

The foregoing summarizes the features of several embodiments and the detailed aspects of the present disclosure. The embodiments described in the present disclosure may be readily used as a basis for designing or modifying other processes and structures to facilitate implementation of the same or similar purpose and/or achieve the same or similar advantages of the embodiments introduced herein. Such equivalents are not departing from the scope of the present disclosure, and various changes, replacements and alterations may be made without departing from the scope of the present disclosure.

## Claims

1. A trench-type semiconductor power device, **characterized by** comprising:
a substrate (102) having a first conductivity type;
a lightly doped region (104) located on the substrate and having the first conductivity type;
a body doped region (106) that is located in the lightly doped region and distant from the substrate, and that has a second conductivity type; a source doped region (108) that is located in the body doped region and distant from the substrate, and that has the first conductivity type; and a trench structure (110), and that has a first depth in a first direction extending from the source doped region to the substrate and that comprises a first semiconductor layer (120) extending in a second direction, the first direction being perpendicular to the second direction, wherein the first semiconductor layer comprises:
a first part (120_1) that is adjacent to the body doped region and the source doped region and serves as a gate electrode having the first conductivity type; and
a second part (120_3) that extends in the second direction and away from the source doped region, and comprises a plurality of first doped regions (120n) having the first conductivity type and a plurality of second doped regions (120p) having the second conductivity type, wherein the plurality of first doped regions and the plurality of second doped regions are arranged alternately in the second direction to form a first diode string (20_1) having one or more back-to-back diodes,
wherein a first end of the first diode string is electrically connected to the gate electrode, and a second end of the first diode string is electrically connected to the source doped region by means of a first connection structure (215).

2. The trench-type semiconductor power device according to claim 1, wherein the first semiconductor layer further comprises: a third part (120_2) that extends in the second direction and distant from the source doped region, that is disposed between the first part and the second part, and that has the first conductivity type, wherein the first end of the first diode string is electrically connected to a second connection structure, and the third part of the first semiconductor layer forms a gate resistor (Rg);
and/or
interfaces between each second doped region and two first doped regions adjacent to the second doped region respectively form a first PN junction and a second PN junction of each of the back-to-back diodes.

3. The trench-type semiconductor power device according to claim 1 or 2, wherein the trench structure further comprises: an insulating layer (115) that surrounds the first semiconductor layer so that the first semiconductor layer is separated from the lightly doped region, the body doped region and the source doped region;
and/or
wherein the first semiconductor layer comprises polysilicon, silicon carbide, gallium nitride, gallium oxide or diamond-based materials

4. The trench-type semiconductor power device according to any preceding claim, further comprising:
an electrostatic discharge protection structure (ESD_P2) that is located above or in the same horizontal plane as the first semiconductor layer, and comprises:
a second semiconductor layer (310) that comprises a plurality of third doped regions (310n) having the first conductivity type and a plurality of fourth doped regions (310p) having the second conductivity type, wherein the plurality of third doped regions and the plurality of fourth doped regions are staggered to form a second diode string (20_2) having one or more back-to-back diodes,
wherein a first end of the second diode string is electrically connected to the source doped region by means of the first connection structure (215), and a second end of the second diode string is electrically connected to the first end of the first diode string by means of a second connection structure (225).

5. The trench-type semiconductor power device according to claim 4, wherein the first semiconductor layer is separated from the electrostatic discharge protection structure;
or
wherein the electrostatic discharge protection structure is located above the first semiconductor layer, and the second part of the first semiconductor layer abuts against the second semiconductor layer of the electrostatic discharge protection structure.

6. The trench-type semiconductor power device according to any one of claims 1 to 3, further comprising:
a shielding structure (111) that surrounds the trench structure (110), is separated from the first diode string (20_1) by penetrating through the lightly doped region and the body doped region, and comprises a second semiconductor layer (310), wherein the second semiconductor layer comprises:
a fourth part (122) that has the first conductivity type and is connected to the source doped region by means of the first connection structure (215),
wherein in the first direction, the depth of the shielding structure is greater than the first depth.

7. The trench-type semiconductor power device according to claim 6, wherein the second semiconductor layer further comprises:
a fifth part (122) that is distant from the source doped region and that comprises a plurality of third doped regions (122n) having the first conductivity type and a plurality of fourth doped regions (122p) having the second conductivity type, wherein the plurality of third doped regions and the plurality of fourth doped regions are staggered to form one or more second diode strings (20_2),
wherein each second diode string comprises one or more back-to-back diodes, and a first end of each second diode string is connected to the first end of the first diode string by means of a second connection structure (225) and a second end thereof is connected to the source doped region by means of the first connection structure (215).

8. The trench-type semiconductor power device according to claim 6 or 7, further comprising:
an electrostatic discharge protection structure that is located above or in the same horizontal plane as the first semiconductor layer, and comprises:
a third semiconductor layer (124) that comprises a plurality of fifth doped regions (124n) having the first conductivity type and a plurality of sixth doped regions (124p) having the second conductivity type, wherein the plurality of fifth doped regions and the plurality of sixth doped regions are staggered to form a third diode string having one or more back-to-back diodes,
wherein a first end of the third diode string is electrically connected to the first end of the first diode string, and a second end of the third diode string is electrically connected to the source doped region.

9. The trench-type semiconductor power device according to claim 8, wherein the shielding structure (111) is disposed between the electrostatic discharge protection structure and the first diode string, and wherein: the shielding structure is separated from the electrostatic discharge protection structure, or the second semiconductor layer of the shielding structure abuts against the third semiconductor layer of the electrostatic discharge protection structure.

10. The trench-type semiconductor power device according to any one of claims 1 to 3, further comprising:
a shielding structure (111) comprising a second semiconductor layer having the first conductivity type,
wherein the trench structure further comprises:
a third semiconductor layer (124) located between the first semiconductor layer and the lightly doped region, wherein the third semiconductor layer comprises:
a fourth part (124_1) that has the first conductivity type and overlaps the first semiconductor layer in the first direction; and
a fifth part (124_2) that is adjacent to the first diode string and that does not overlap the first semiconductor layer in the first direction,
wherein the first semiconductor layer is separated from the third semiconductor layer by penetrating through an insulating layer, and
wherein the shielding structure is adjacent to the fifth part of the third semiconductor layer and separated from the trench structure by penetrating through the lightly doped region and the body doped region.

11. The trench-type semiconductor power device according to claim 10, wherein in the first direction, the thickness of the fourth part of the third semiconductor layer and the thickness of the first semiconductor layer are less than the first depth.

12. The trench-type semiconductor power device according to claim 10 or 11, wherein the fifth part of the third semiconductor layer has the first conductivity type, and the third semiconductor layer and the second semiconductor layer are electrically connected to the source doped region by means of the first connection structure.

13. The trench-type semiconductor power device according to any one of claims 10 to 12, wherein the fifth part of the third semiconductor layer comprises a plurality of third doped regions (124n) having the first conductivity type and a plurality of fourth doped regions (124p) having the second conductivity type, wherein the plurality of third doped regions and the plurality of fourth doped regions are staggered to form a second diode string having one or more back-to-back diodes, wherein a first end of the second diode string is connected to the first end of the first diode string by means of a second connection structure, and a second end of the second diode string is connected to the source doped region by means of the first connection structure.

14. The trench-type semiconductor power device according to claim 13, further comprising:
an electrostatic discharge protection structure that is located above or in the same horizontal plane as the first semiconductor layer, and comprises:
a fourth semiconductor layer (310) that comprises a plurality of fifth doped regions (310n) having the first conductivity type and a plurality of sixth doped regions (310p) having the second conductivity type, wherein the plurality of fifth doped regions and the plurality of sixth doped regions are staggered to form a third diode string having one or more back-to-back diodes,
wherein a first end of the third diode string is connected to the first end of the first diode string by means of the second connection structure, and a second end of the third diode string is connected to the source doped region by means of the first connection structure.

15. The trench-type semiconductor power device according to claim 14, wherein the shielding structure is disposed between the electrostatic discharge protection structure and the trench structure, and wherein: the shielding structure is separated from the electrostatic discharge protection structure; or the second semiconductor layer of the shielding structure abuts against the fourth semiconductor layer of the electrostatic discharge protection structure.

## Patentansprüche

1. Halbleiter-Leistungsvorrichtung vom Grabentyp, **dadurch gekennzeichnet, dass** es Folgendes umfasst:
ein Substrat (102), das einen ersten Leitfähigkeitstyp aufweist;
einen schwach dotierten Bereich (104), die auf dem Substrat angeordnet ist und den ersten Leitfähigkeitstyp aufweist;
einen körperdotierten Bereich (106), der sich in dem schwach dotierten Bereich befindet und vom Substrat entfernt ist, und der einen zweiten Leitfähigkeitstyp aufweist; einen quellendotierten Bereich (108), der sich in dem körperdotierten Bereich befindet und vom Substrat entfernt ist, und der den ersten Leitfähigkeitstyp aufweist; und eine Grabenstruktur (110), die eine erste Tiefe in einer ersten Richtung aufweist, die sich von dem quellendotierten Bereich zum Substrat erstreckt, und die eine erste Halbleiterschicht (120) umfasst, die sich in einer zweiten Richtung erstreckt, wobei die erste Richtung senkrecht zur zweiten Richtung ist, wobei die erste Halbleiterschicht Folgendes umfasst:
einen ersten Teil (120_1), der an den körperdotierten Bereich und den quellendotierten Bereich angrenzt und als eine Gate-Elektrode dient, die den ersten Leitfähigkeitstyp aufweist; und
einen zweiten Teil (120_3), der sich in der zweiten Richtung und vom quellendotierten Bereich weg erstreckt und eine Vielzahl von ersten dotierten Bereichen (120n), die den ersten Leitfähigkeitstyp aufweisen, und eine Vielzahl von zweiten dotierten Bereichen (120p), die den zweiten Leitfähigkeitstyp aufweisen, umfasst, wobei die Vielzahl von ersten dotierten Bereichen und die Vielzahl von zweiten dotierten Bereichen abwechselnd in der zweiten Richtung angeordnet sind, um eine erste Diodenkette (20_1) zu bilden, die eine oder mehrere antiparallel geschaltete Dioden aufweist,
wobei ein erstes Ende der ersten Diodenkette elektrisch mit der Gate-Elektrode verbunden ist und ein zweites Ende der ersten Diodenkette mittels einer ersten Verbindungsstruktur (215) elektrisch mit dem quellendotierten Bereich verbunden ist.

2. Halbleiter-Leistungsvorrichtung vom Grabentyp nach Anspruch 1, wobei die erste Halbleiterschicht weiter Folgendes umfasst: einen dritten Teil (120_2), der sich in der zweiten Richtung erstreckt und von dem quellendotierten Bereich entfernt ist, der zwischen dem ersten Teil und dem zweiten Teil angeordnet ist, und der den ersten Leitfähigkeitstyp aufweist, wobei das erste Ende der ersten Diodenkette elektrisch mit einer zweiten Verbindungsstruktur verbunden ist und der dritte Teil der ersten Halbleiterschicht einen Gate-Widerstand (Rg) bildet;
und/oder
Grenzflächen zwischen jedem zweiten dotierten Bereich und zwei ersten dotierten Bereichen, die jeweils an den zweiten dotierten Bereich angrenzen, einen ersten PN-Übergang und einen zweiten PN-Übergang jeder der antiparallel geschalteten Dioden bilden.

3. Halbleiter-Leistungsvorrichtung vom Grabentyp nach Anspruch 1 oder 2, wobei die Grabenstruktur weiter Folgendes umfasst: eine Isolierschicht (115), die die erste Halbleiterschicht umgibt, sodass die erste Halbleiterschicht von dem schwach dotierten Bereich, dem körperdotierten Bereich und dem quellendotierten Bereich getrennt ist;
und/oder
wobei die erste Halbleiterschicht Polysilizium, Siliziumkarbid, Galliumnitrid, Galliumoxid oder diamantbasierte Materialien umfasst.

4. Halbleiter-Leistungsvorrichtung vom Grabentyp nach einem vorstehenden Anspruch, weiter umfassend:
eine elektrostatische Entladungsschutzstruktur (ESD_P2), die sich oberhalb oder in derselben horizontalen Ebene ersten Halbleiterschicht befindet und Folgendes umfasst:
eine zweite Halbleiterschicht (310), die eine Vielzahl von dritten dotierten Bereichen (310n), die den ersten Leitfähigkeitstyp aufweisen, und eine Vielzahl von vierten dotierten Bereichen (310p), die den zweiten Leitfähigkeitstyp aufweisen, umfasst, wobei die Vielzahl von dritten dotierten Bereichen und die Vielzahl von vierten dotierten Bereichen versetzt sind, um eine zweite Diodenkette (20_2) zu bilden, die eine oder mehrere antiparallel geschaltete Dioden aufweist,
wobei ein erstes Ende der zweiten Diodenkette mittels der ersten Verbindungsstruktur (215) elektrisch mit dem quellendotierten Bereich verbunden ist und ein zweites Ende der zweiten Diodenkette mittels einer zweiten Verbindungsstruktur (225) elektrisch mit dem ersten Ende der ersten Diodenkette verbunden ist.

5. Halbleiter-Leistungsvorrichtung vom Grabentyp nach Anspruch 4, wobei die erste Halbleiterschicht von der elektrostatischen Entladungsschutzstruktur getrennt ist;
oder
wobei die elektrostatische Entladungsschutzstruktur oberhalb der ersten Halbleiterschicht angeordnet ist und der zweite Teil der ersten Halbleiterschicht an die zweite Halbleiterschicht der elektrostatischen Entladungsschutzstruktur anstößt.

6. Halbleiter-Leistungsvorrichtung vom Grabentyp nach einem der Ansprüche 1 bis 3, weiter umfassend:
eine Abschirmungsstruktur (111), die die Grabenstruktur (110) umgibt, von der ersten Diodenkette (20_1) durch Durchdringen des schwach dotierten Bereichs und des körperdotierten Bereichs getrennt ist und eine zweite Halbleiterschicht (310) umfasst, wobei die zweite Halbleiterschicht Folgendes umfasst:
einen vierten Teil (122), der den ersten Leitfähigkeitstyp aufweist und mittels der ersten Verbindungsstruktur (215) mit dem quellendotierten Bereich verbunden ist,
wobei in der ersten Richtung die Tiefe der Abschirmungsstruktur größer ist als die erste Tiefe.

7. Halbleiter-Leistungsvorrichtung vom Grabentyp nach Anspruch 6, wobei die zweite Halbleiterschicht weiter Folgendes umfasst:
einen fünften Teil (122), der von dem quellendotierten Bereich entfernt ist und eine Vielzahl von dritten dotierten Bereichen (122n), die den ersten Leitfähigkeitstyp aufweisen, und eine Vielzahl von vierten dotierten Bereichen (122p), die den zweiten Leitfähigkeitstyp aufweisen, umfasst, wobei die Vielzahl von dritten dotierten Bereichen und die Vielzahl von vierten dotierten Bereichen versetzt sind, um eine oder mehrere zweite Diodenketten zu bilden (20_2),
wobei jede zweite Diodenkette eine oder mehrere antiparallel geschaltete Dioden umfasst und ein erstes Ende jeder zweiten Diodenkette mittels einer zweiten Verbindungsstruktur (225) mit dem ersten Ende der ersten Diodenkette verbunden ist und ein zweites Ende davon mittels der ersten Verbindungsstruktur (215) mit dem quellendotierten Bereich verbunden ist.

8. Halbleiter-Leistungsvorrichtung vom Grabentyp nach Anspruch 6 oder 7, weiter umfassend:
eine elektrostatische Entladungsschutzstruktur, die sich oberhalb oder in derselben horizontalen Ebene ersten Halbleiterschicht befindet und Folgendes umfasst:
eine dritte Halbleiterschicht (124), die eine Vielzahl von fünften dotierten Bereichen (124n), die den ersten Leitfähigkeitstyp aufweisen, und eine Vielzahl von sechsten dotierten Bereichen (124p), die den zweiten Leitfähigkeitstyp aufweisen, umfasst, wobei die Vielzahl von fünften dotierten Bereichen und die Vielzahl von sechsten dotierten Bereichen versetzt sind, um eine dritte Diodenkette zu bilden, die eine oder mehrere antiparallel geschaltete Dioden aufweist,
wobei ein erstes Ende der dritten Diodenkette elektrisch mit dem ersten Ende der ersten Diodenkette verbunden ist und ein zweites Ende der dritten Diodenkette elektrisch mit dem quellendotierten Bereich verbunden ist.

9. Halbleiter-Leistungsvorrichtung vom Grabentyp nach Anspruch 8, wobei die Abschirmungsstruktur (111) zwischen der elektrostatischen Entladungsschutzstruktur und der ersten Diodenkette angeordnet ist und wobei: die Abschirmungsstruktur von der elektrostatischen Entladungsschutzstruktur getrennt ist oder die zweite Halbleiterschicht der Abschirmungsstruktur an die dritte Halbleiterschicht der elektrostatischen Entladungsschutzstruktur anstößt.

10. Halbleiter-Leistungsvorrichtung vom Grabentyp nach einem der Ansprüche 1 bis 3, weiter umfassend:
eine Abschirmungsstruktur (111), umfassend eine zweite Halbleiterschicht, die den ersten Leitfähigkeitstyp aufweist,
wobei die Grabenstruktur weiter Folgendes umfasst:
eine dritte Halbleiterschicht (124), die zwischen der ersten Halbleiterschicht und dem schwach dotierten Bereich angeordnet ist, wobei die dritte Halbleiterschicht Folgendes umfasst:
einen vierten Teil (124_1), der den ersten Leitfähigkeitstyp aufweist und die erste Halbleiterschicht in der ersten Richtung überlappt; und
einen fünften Teil (124_2), der an die erste Diodenkette angrenzt und die erste Halbleiterschicht in der ersten Richtung nicht überlappt,
wobei die erste Halbleiterschicht durch Durchdringen durch eine Isolierschicht von der dritten Halbleiterschicht getrennt ist und
wobei die Abschirmungsstruktur an den fünften Teil der dritten Halbleiterschicht angrenzt und von der Grabenstruktur durch Durchdringen des schwach dotierten Bereichs und des körperdotierten Bereichs getrennt ist.

11. Halbleiter-Leistungsvorrichtung vom Grabentyp nach Anspruch 10, wobei in der ersten Richtung die Dicke des vierten Teils der dritten Halbleiterschicht und die Dicke der ersten Halbleiterschicht kleiner als die erste Tiefe sind.

12. Halbleiter-Leistungsvorrichtung vom Grabentyp nach Anspruch 10 oder 11, wobei der fünfte Teil der dritten Halbleiterschicht den ersten Leitfähigkeitstyp aufweist und die dritte Halbleiterschicht und die zweite Halbleiterschicht mittels der ersten Verbindungsstruktur elektrisch mit dem quellendotierten Bereich verbunden sind.

13. Halbleiter-Leistungsvorrichtung vom Grabentyp nach einem der Ansprüche 10 bis 12, wobei der fünfte Teil der dritten Halbleiterschicht eine Vielzahl von dritten dotierten Bereichen (124n), die den ersten Leitfähigkeitstyp aufweisen, und eine Vielzahl von vierten dotierten Bereichen (124p), die den zweiten Leitfähigkeitstyp aufweisen, umfasst, wobei die Vielzahl von dritten dotierten Bereichen und die Vielzahl von vierten dotierten Bereichen versetzt sind, um eine zweite Diodenkette zu bilden, die eine oder mehrere antiparallel geschaltete Dioden aufweist, wobei ein erstes Ende der zweiten Diodenkette mittels einer zweiten Verbindungsstruktur mit dem ersten Ende der ersten Diodenkette verbunden ist und ein zweites Ende der zweiten Diodenkette mittels der ersten Verbindungsstruktur mit dem quellendotierten Bereich verbunden ist.

14. Halbleiter-Leistungsvorrichtung vom Grabentyp nach Anspruch 13, weiter umfassend:
eine elektrostatische Entladungsschutzstruktur, die sich oberhalb oder in derselben horizontalen Ebene ersten Halbleiterschicht befindet und Folgendes umfasst:
eine vierte Halbleiterschicht (310), die eine Vielzahl von fünften dotierten Bereichen (310n), die den ersten Leitfähigkeitstyp aufweisen, und eine Vielzahl von sechsten dotierten Bereichen (310p), die den zweiten Leitfähigkeitstyp aufweisen, umfasst, wobei die Vielzahl von fünften dotierten Bereichen und die Vielzahl von sechsten dotierten Bereichen versetzt sind, um eine dritte Diodenkette zu bilden, die eine oder mehrere antiparallel geschaltete Dioden aufweist,
wobei ein erstes Ende der dritten Diodenkette mittels der zweiten Verbindungsstruktur mit dem ersten Ende der ersten Diodenkette verbunden ist und ein zweites Ende der dritten Diodenkette mittels der ersten Verbindungsstruktur mit dem quellendotierten Bereich verbunden ist.

15. Halbleiter-Leistungsvorrichtung vom Grabentyp nach Anspruch 14, wobei die Abschirmungsstruktur zwischen der elektrostatischen Entladungsschutzstruktur und der Grabenstruktur angeordnet ist und wobei: die Abschirmungsstruktur von der elektrostatischen Entladungsschutzstruktur getrennt ist; oder die zweite Halbleiterschicht der Abschirmungsstruktur an die vierte Halbleiterschicht der elektrostatischen Entladungsschutzstruktur anstößt.

## Revendications

1. Dispositif de puissance à semi-conducteur de type à tranchée, **caractérisé en ce qu'**il comprend :
un substrat (102) présentant un premier type de conductivité ;
une région faiblement dopée (104) située sur le substrat et présentant le premier type de conductivité ;
une région dopée de corps (106) qui est située dans la région faiblement dopée et éloignée du substrat, et qui présente un second type de conductivité ; une région dopée de source (108) qui est située dans la région dopée de corps et éloignée du substrat, et qui présente le premier type de conductivité ; et une structure de tranchée (110), et qui présente une première profondeur dans une première direction s'étendant de la région dopée de source au substrat et qui comprend une première couche semi-conductrice (120) s'étendant dans une seconde direction, la première direction étant perpendiculaire à la seconde direction, dans lequel la première couche semi-conductrice comprend :
une première partie (120_1) qui est adjacente à la région dopée de corps et à la région dopée de source et sert d'électrode de grille présentant le premier type de conductivité ; et
une deuxième partie (120_3) qui s'étend dans la seconde direction et éloignée de la région dopée de source, et comprend une pluralité de premières régions dopées (120n) présentant le premier type de conductivité et une pluralité de deuxièmes régions dopées (120p) présentant le second type de conductivité, dans lequel la pluralité de premières régions dopées et la pluralité de deuxièmes régions dopées sont agencées alternativement dans la seconde direction pour former une première chaîne de diodes (20_1) présentant une ou plusieurs diodes tête-bêche,
dans lequel une première extrémité de la première chaîne de diodes est raccordée électriquement à l'électrode de grille, et une seconde extrémité de la première chaîne de diodes est raccordée électriquement à la région dopée de source au moyen d'une première structure de raccordement (215).

2. Dispositif de puissance à semi-conducteur de type à tranchée selon la revendication 1, dans lequel la première couche semi-conductrice comprend en outre : une troisième partie (120_2) qui s'étend dans la seconde direction et éloignée de la région dopée de source, qui est disposée entre la première partie et la deuxième partie, et qui présente le premier type de conductivité, dans lequel la première extrémité de la première chaîne de diodes est raccordée électriquement à une seconde structure de raccordement, et la troisième partie de la première couche semi-conductrice forme une résistance de grille (Rg) ;
et/ou
des interfaces entre chaque deuxième région dopée et deux premières régions dopées adjacentes à la deuxième région dopée forment respectivement une première jonction PN et une seconde jonction PN de chacune des diodes tête-bêche.

3. Dispositif de puissance à semi-conducteur de type à tranchée selon la revendication 1 ou 2, dans lequel la structure de tranchée comprend en outre : une couche isolante (115) qui entoure la première couche semi-conductrice de sorte que la première couche semi-conductrice soit séparée de la région faiblement dopée, de la région dopée de corps et de la région dopée de source ;
et/ou
dans lequel la première couche semi-conductrice comprend du polysilicium, du carbure de silicium, du nitrure de gallium, de l'oxyde de gallium ou des matériaux à base de diamant.

4. Dispositif de puissance à semi-conducteur de type à tranchée selon une quelconque revendication précédente, comprenant en outre :
une structure de protection contre les décharges électrostatiques (ESD_P2) qui est située au-dessus ou dans le même plan horizontal que la première couche semi-conductrice, et comprend :
une deuxième couche semi-conductrice (310) qui comprend une pluralité de troisièmes régions dopées (310n) présentant le premier type de conductivité et une pluralité de quatrièmes régions dopées (310p) présentant le second type de conductivité, dans lequel la pluralité de troisièmes régions dopées et la pluralité de quatrièmes régions dopées sont décalées pour former une deuxième chaîne de diodes (20_2) présentant une ou plusieurs diodes tête-bêche,
dans lequel une première extrémité de la deuxième chaîne de diodes est raccordée électriquement à la région dopée de source au moyen de la première structure de raccordement (215), et une seconde extrémité de la deuxième chaîne de diodes est raccordée électriquement à la première extrémité de la première chaîne de diodes au moyen d'une seconde structure de raccordement (225).

5. Dispositif de puissance à semi-conducteur de type à tranchée selon la revendication 4, dans lequel la première couche semi-conductrice est séparée de la structure de protection contre les décharges électrostatiques ;
ou
dans lequel la structure de protection contre les décharges électrostatiques est située au-dessus de la première couche semi-conductrice, et la deuxième partie de la première couche semi-conductrice vient en butée contre la deuxième couche semi-conductrice de la structure de protection contre les décharges électrostatiques.

6. Dispositif de puissance à semi-conducteur de type à tranchée selon l'une quelconque des revendications 1 à 3, comprenant en outre :
une structure de blindage (111) qui entoure la structure de tranchée (110), est séparée de la première chaîne de diodes (20_1) en pénétrant à travers la région faiblement dopée et la région dopée de corps, et comprend une deuxième couche semi-conductrice (310), dans lequel la deuxième couche semi-conductrice comprend :
une quatrième partie (122) qui présente le premier type de conductivité et est raccordée à la région dopée de source au moyen de la première structure de raccordement (215),
dans lequel, dans la première direction, la profondeur de la structure de blindage est supérieure à la première profondeur.

7. Dispositif de puissance à semi-conducteur de type à tranchée selon la revendication 6, dans lequel la deuxième couche semi-conductrice comprend en outre :
une cinquième partie (122) qui est distante de la région dopée de source et qui comprend une pluralité de troisièmes régions dopées (122n) présentant le premier type de conductivité et une pluralité de quatrièmes régions dopées (122p) présentant le second type de conductivité, dans lequel la pluralité de troisièmes régions dopées et la pluralité de quatrièmes régions dopées sont décalées pour former une ou plusieurs deuxièmes chaînes de diodes (20_2),
dans lequel chaque deuxième chaîne de diodes comprend une ou plusieurs diodes tête-bêche, et une première extrémité de chaque deuxième chaîne de diodes est raccordée à la première extrémité de la première chaîne de diodes au moyen d'une seconde structure de raccordement (225) et une seconde extrémité de celle-ci est raccordée à la région dopée de source au moyen de la première structure de raccordement (215).

8. Dispositif de puissance à semi-conducteur de type à tranchée selon la revendication 6 ou 7, comprenant en outre :
une structure de protection contre les décharges électrostatiques qui est située au-dessus ou dans le même plan horizontal que la première couche semi-conductrice, et comprend :
une troisième couche semi-conductrice (124) qui comprend une pluralité de cinquièmes régions dopées (124n) présentant le premier type de conductivité et une pluralité de sixièmes régions dopées (124p) présentant le second type de conductivité, dans lequel la pluralité de cinquièmes régions dopées et la pluralité de sixièmes régions dopées sont décalées pour former une troisième chaîne de diodes présentant une ou plusieurs diodes tête-bêche,
dans lequel une première extrémité de la troisième chaîne de diodes est raccordée électriquement à la première extrémité de la première chaîne de diodes, et une seconde extrémité de la troisième chaîne de diodes est raccordée électriquement à la région dopée de source.

9. Dispositif de puissance à semi-conducteur de type à tranchée selon la revendication 8, dans lequel la structure de blindage (111) est disposée entre la structure de protection contre les décharges électrostatiques et la première chaîne de diodes, et dans lequel : la structure de blindage est séparée de la structure de protection contre les décharges électrostatiques, ou la deuxième couche semi-conductrice de la structure de blindage vient en butée contre la troisième couche semi-conductrice de la structure de protection contre les décharges électrostatiques.

10. Dispositif de puissance à semi-conducteur de type à tranchée selon l'une quelconque des revendications 1 à 3, comprenant en outre :
une structure de blindage (111) comprenant une deuxième couche semi-conductrice présentant le premier type de conductivité,
dans lequel la structure de tranchée comprend en outre :
une troisième couche semi-conductrice (124) située entre la première couche semi-conductrice et la région faiblement dopée, dans lequel la troisième couche semi-conductrice comprend :
une quatrième partie (124_1) qui présente le premier type de conductivité et chevauche la première couche semi-conductrice dans la première direction ; et
une cinquième partie (124_2) qui est adjacente à la première chaîne de diodes et qui ne chevauche pas la première couche semi-conductrice dans la première direction,
dans lequel la première couche semi-conductrice est séparée de la troisième couche semi-conductrice par pénétration d'une couche isolante, et
dans lequel la structure de blindage est adjacente à la cinquième partie de la troisième couche semi-conductrice et séparée de la structure de tranchée par pénétration de la région faiblement dopée et de la région dopée de corps.

11. Dispositif de puissance à semi-conducteur de type à tranchée selon la revendication 10, dans lequel, dans la première direction, l'épaisseur de la quatrième partie de la troisième couche semi-conductrice et l'épaisseur de la première couche semi-conductrice sont inférieures à la première profondeur.

12. Dispositif de puissance à semi-conducteur de type à tranchée selon la revendication 10 ou 11, dans lequel la cinquième partie de la troisième couche semi-conductrice présente le premier type de conductivité, et la troisième couche semi-conductrice et la deuxième couche semi-conductrice sont raccordées électriquement à la région dopée de source au moyen de la première structure de raccordement.

13. Dispositif de puissance à semi-conducteur de type à tranchée selon l'une quelconque des revendications 10 à 12, dans lequel la cinquième partie de la troisième couche semi-conductrice comprend une pluralité de troisièmes régions dopées (124n) présentant le premier type de conductivité et une pluralité de quatrièmes régions dopées (124p) présentant le second type de conductivité, dans lequel la pluralité de troisièmes régions dopées et la pluralité de quatrièmes régions dopées sont décalées pour former une deuxième chaîne de diodes présentant une ou plusieurs diodes tête-bêche, dans lequel une première extrémité de la deuxième chaîne de diodes est raccordée à la première extrémité de la première chaîne de diodes au moyen d'une seconde structure de raccordement, et une seconde extrémité de la deuxième chaîne de diodes est raccordée à la région dopée de source au moyen de la première structure de raccordement.

14. Dispositif de puissance à semi-conducteur de type à tranchée selon la revendication 13, comprenant en outre :
une structure de protection contre les décharges électrostatiques qui est située au-dessus ou dans le même plan horizontal que la première couche semi-conductrice, et comprend :
une quatrième couche semi-conductrice (310) qui comprend une pluralité de cinquièmes régions dopées (310n) présentant le premier type de conductivité et une pluralité de sixièmes régions dopées (310p) présentant le second type de conductivité, dans lequel la pluralité de cinquièmes régions dopées et la pluralité de sixièmes régions dopées sont décalées pour former une troisième chaîne de diodes présentant une ou plusieurs diodes tête-bêche,
dans lequel une première extrémité de la troisième chaîne de diodes est raccordée à la première extrémité de la première chaîne de diodes au moyen de la seconde structure de raccordement, et une seconde extrémité de la troisième chaîne de diodes est raccordée à la région dopée de source au moyen de la première structure de raccordement.

15. Dispositif de puissance à semi-conducteur de type à tranchée selon la revendication 14, dans lequel la structure de blindage est disposée entre la structure de protection contre les décharges électrostatiques et la structure de tranchée, et dans lequel : la structure de blindage est séparée de la structure de protection contre les décharges électrostatiques; ou la deuxième couche semi-conductrice de la structure de blindage vient en butée contre la quatrième couche semi-conductrice de la structure de protection contre les décharges électrostatiques.
